# EUROPEAN PATENT SPECIFICATION

(11) **EP 3 905 300 B1**
(45) Date of publication and mention of the grant of the patent: **25.11.2026**
(21) Application number: 21160572.0
(22) Date of filing: 16.07.2009
(51) Int. Cl.: H01J 27/18, H01J 37/08, G21G 4/08, H05H 1/18, G21G 1/10

(54) **ECR PARTICLE BEAM SOURCE APPARATUS**
ECR-PARTIKELSTRAHL-QUELLENVORRICHTUNG
APPAREIL DE SOURCE DE FAISCEAU DE PARTICULES ECR

(30) Priority: 15.05.2009 US 17885709 P
(43) Date of publication of application: 03.11.2021
(62) Document number(s) of the earlier application(s) in accordance with Art. 76 EPC: 09790533.5 / 2 430 637
(73) Proprietor: Nusano, Inc., Valencia, CA 91355 (US)
(72) Inventor: ROSENTHAL, Glenn B., Los Angeles, CA 90034 (US)
(74) Representative: Walaski, Jan Filip

(56) References cited:
- JP-A- 2003 257 329
- US-A- 5 506 475
- US-A- 5 981 955
- US-A1- 2004 238 753

## Description

### BACKGROUND

This disclosure is related to ion sources, and more particularly to high intensity ion sources.

Ion sources may be used to generate ion beams useful in a number of applications. For example, the beams may be used to bombard targets to drive nuclear reactions for the production of isotopes.

Some ions sources ionize neutral targets via collisions with energetic electrons. Electron Cyclotron Resonant (ECR) plasma sources generate energetic electrons by exciting the cyclotron motion of the electrons within a magnetic field. The ECR plasma source is located in a vacuum chamber to control the gas that is ionized, and to reduce the pressure allowing the electrons to reach ionization energy.

A charged particle placed in a uniform magnetic field will gyrate around the magnetic field with a frequency given by the electron cyclotron frequency. ${ω}_{ce} = \frac{eB}{m}$

If the magnetic field is not uniform, the electron still gyrates around the magnetic field, but the orbit and frequency become somewhat more complicated. ECR ion sources do not require a uniform magnetic field to operate. In fact, many of them operate in highly non-uniform magnetic fields. By applying an oscillating electric field, the cyclotron motion of the electrons can be excited. If the oscillating electric field is resonant with the electron cyclotron frequency and couples to the electron motion, the electrons will gain energy. The highest coupling would be an electric field that rotated about the magnetic field in the same direction as the electrons, and at the same rate. This electric field would look like a DC electric field in the frame of the electrons. Good coupling can also be obtained with a linear polarized electric field that oscillates perpendicular to the magnetic field. As the electrons gain energy they will collide with any gas within the source, ionizing the background gas. This forms plasma and creates more electrons that can ionize more background gas. This prior art process continues as the plasma density increases until losses are balanced with production.

In prior art devices, the balance occurs long before a powerful beam can be generated, and a powerful beam is what is needed to strike and transmute target material into such things as useful medical isotopes. Many isotopes are, in theory, thought to be useful, but heretofore their small obtainable quantities and short half lives, prevent their use.

An ion source comprising electron cyclotron resonance excitation and ion cyclotron resonance excitation is known from document US 5 981 955 A.

### SUMMARY

The inventors have realized that a high intensity source of multiply charged ions in a selected ionization state may be provided.

An ion source according to the present invention is defined in claim 1.

Preferred embodiments are defined in dependent claims 2-14.

Various embodiments may include any of the above described features either alone or in any combination.

It is to be understood that as used herein, the term gas may refer to a single component gas (e.g. ⁴He gas), or a multi-component gas (e.g. ³He/⁴He gas mix, a He/Xe gas mix, a He/O₂ gas mix, etc.).

Scientific notation known in the art has been used herein to describe various nuclear reactions. For a reaction described in the form A(b,c)D, "A" is the target nucleus, or irradiated material, "b" is a bombarding particle, "c" is an emitted particle, and "D" is the product or residual nucleus. For a reaction described in the form A(b,c)D1(D2), D1 and D2 primary and secondary products of the reaction.

These and other aspects of the present invention will become apparent to those skilled in the art after considering the following detailed specification along with the accompanying drawings where:

### BRIEF DESCRIPTION OF THE DRAWINGS

FIG. 1 is a block diagram of an ion beam system;
FIG. 1A is a block diagram of an ion beam system for making useful isotopes;
FIG. 1B is a block diagram of an ion beam system adapted for treatment of radio active waste from commercial nuclear power plants;
FIG. 1C is a block diagram of an ion beam system adapted for medical treatment, e.g. treatment of internal growths;
FIG. 2A is an operational schematic of an ion beam system
FIG. 2B is an operational schematic of an ion beam system showing modified insulators;
FIG. 2C is an operational schematic of an ion beam system showing a grounded chamber;
FIG. 2D is an operational schematic of an ion beam system showing external ICR antenna.
FIG. 3A is a graph of the cross-section for formation of He⁺ and He⁺⁺ by electron impact on neutral He versus electron energy;
FIG. 3B is a graph of electron impact ionization cross-section for the first six ionization states of Xenon;
FIGS. 3C and 3D shows graphs of the cross-sections for electron impact ionization as a function of electron energy, of neutral He (He + e⁻⁻ → He⁺ 2e⁻) and He⁺ (He⁺ + e⁻ → He⁺⁺ 2e⁻);
FIG. 4 is a graph of magnetic field magnitude as a function of axial position in an ion source;
FIG. 5 is a graphical view of the loss cone associated with the magnetic fields of FIG 4;
FIGS. 6A and 6B are schematic diagrams of capacitor plate ICR antennae, FIG. 6A depicting a linear drive system and FIG. 6B depicting a circular drive system with the horizontal plates driven 90° out of phase with the vertical plates.
FIG. 7 is a schematic diagram of a split ring antenna system for the ICR;
FIG. 8 is schematic diagram of a bi-filer antenna where the to coils are driven 90° out of phase to generate a rotating electric field for the ICR;

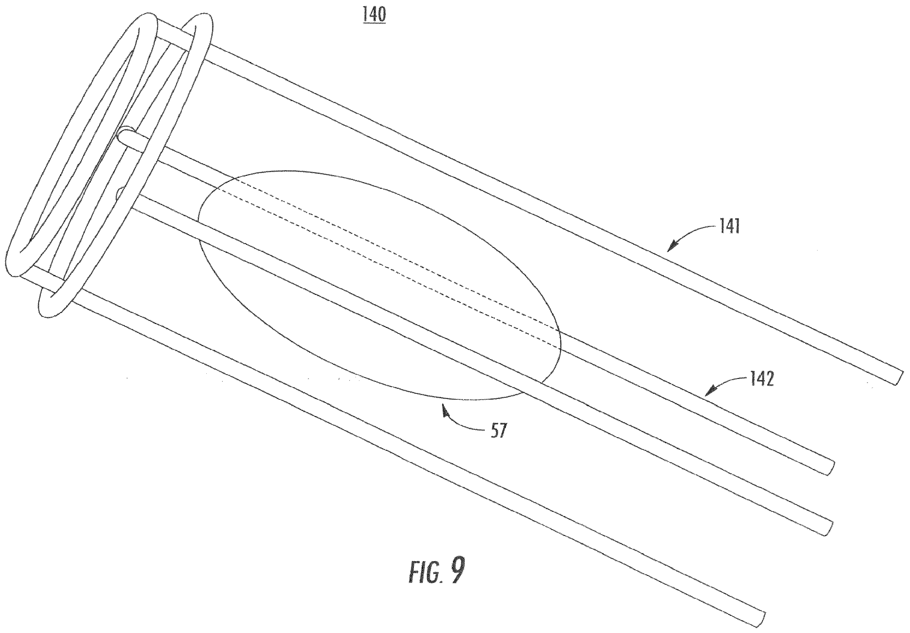

Fig. 9 is schematic diagram of an untwisted bi-filer antenna where the two coils are driven 90° out of phase to generate a rotating electric field for the ICR;
FIGS. 10A and 10B are graphical representations of the ECR resonance zones for the magnetic confinement fields when the ECR is operating in an on-resonant and an off-resonant mode, respectively;
FIG. 11 is a simplified cross-sectional view of a sputter source implemented with an axially located target, showing different support and bias material, and sputter material;
FIG. 12 is a simplified cross-sectional view of a sputter source implemented with an annular target;
FIG. 13 is a simplified cross-sectional view of a sputter source implemented as a conical sputter target;
FIG. 14 shows a multipole radial confinement magnet.
FIG. 14A shows the magnetic field generated by a multipole radial confinement magnet.
FIG. 15 is a plot of total extracted beam current as a function of central magnetic field strength for an ion beam system.
FIG. 16 shows time-of-flight mass spectrometer data for an ion beam generated in the ECR resonant mode of operation.
FIGS. 17A-C illustrate an exemplary target and target feed system.

### DETAILED DESCRIPTION

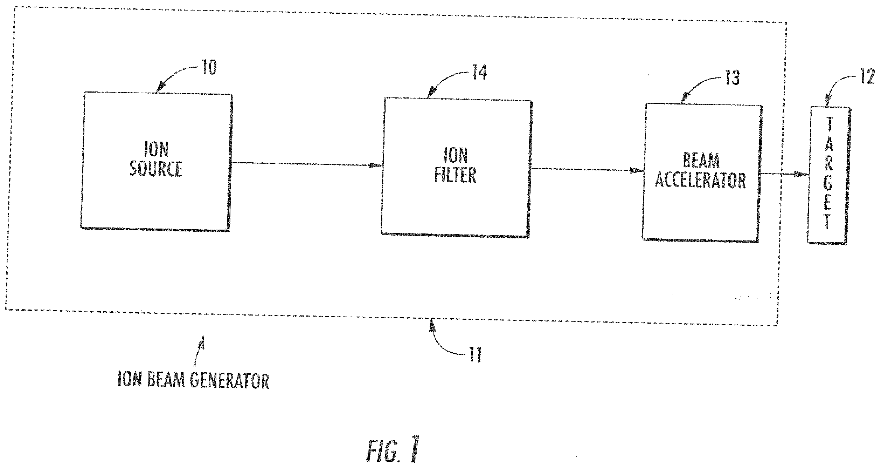

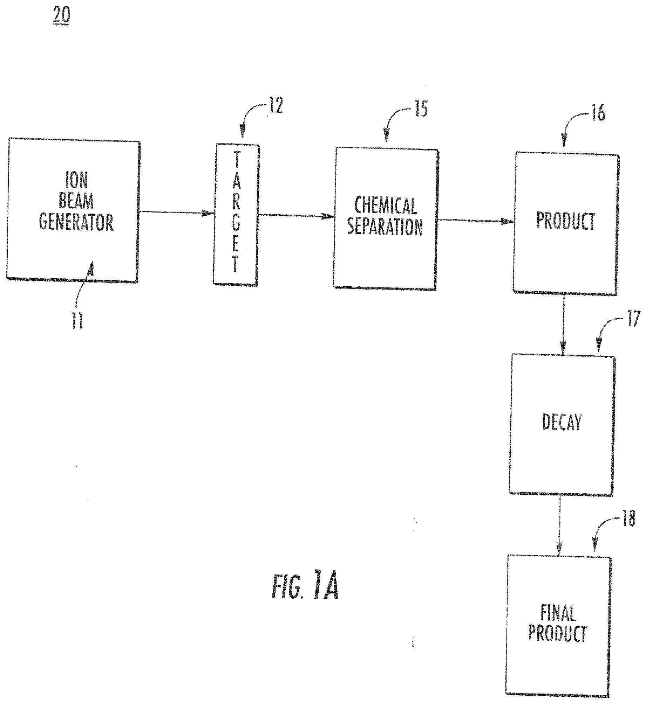

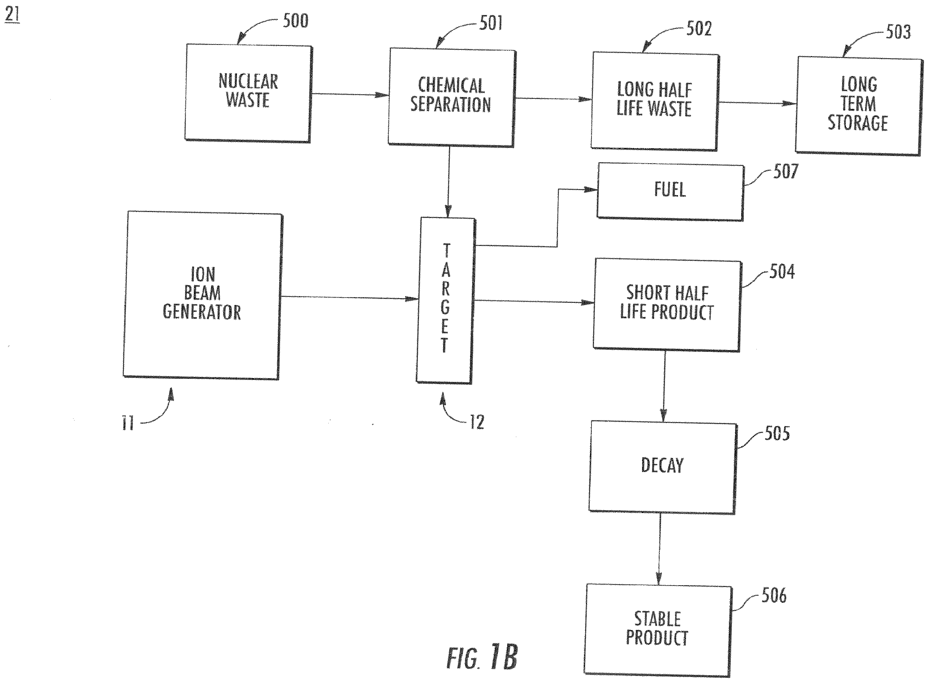

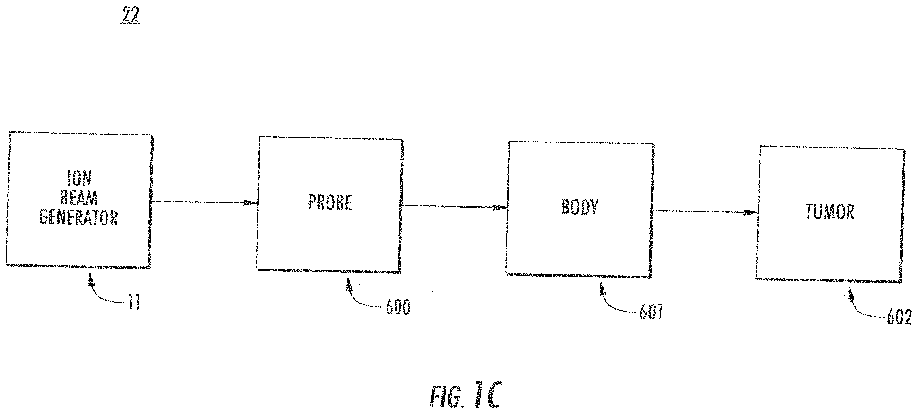

Referring to FIG. 1, an Ion beam generator 11 generates an ion beam and directs it to target 12 to cause a nuclear reaction, e.g. to transmute atoms in target 12 to produce a desired isotope. Ion beam generator 11 includes an ion source 10 of the type described herein, which produces a beam (e.g. a high intensity beam) including ions in a selected final ionization state. Ion beam generator 11 also includes a beam accelerator 13, which accelerates the beam from source 10, and directs it to target 12. Optionally, ion beam generator 11 also includes a filter for filtering ions ion the beam, e.g. based on the charge or mass of the ions. In some embodiments, accelerator 13 acts as a filter. For example, a cyclotron accelerator will naturally separate ions having different ionization states.

Beam accelerator 13 may be any suitable accelerator known in the art. In some embodiments, the accelerator system is a hybrid RFQ-DTL (Radio Frequency Quadrapole - Drift Tube LINAC) system available for modification from various vendors. Other accelerator systems such as almost any LINAC or cyclotron could be used.

A number of coupling methods can be used between ion source 10 and accelerator 13. For high intensity beams, a magnetic lens system is advantageous. For low intensity beams, an electrostatic lens system is more economic, compact, and effective. Generally, using a magnetic lens allows for an easy way to implement a particle filter that will reject any He⁺ within the beam where the selected final ion state is He⁺⁺.

FIG. 1A shows a system 20 featuring ion beam generator 11. Ion beam generator 11 bombards target 12 with ions to transmute atoms in target 12 to produce a desired isotope. The transmuted target undergoes chemical separation 15 to provide a pure sample of product isotope 16. In some embodiments, product isotope 16 is an intermediate product, and undergoes decay 17 resulting in final product 18. In some embodiments, the intermediate product is a relatively long lived radio-isotope in comparison to the final product isotope. In some embodiments, final product 18 is an isotope suitable for use in medical treatment or diagnostic applications, research applications (e.g. radio-marking), energy generation applications (e.g. as nuclear fuel), etc.

FIG. 1B shows a system 21 for treatment of nuclear waste 500. Nuclear waste (e.g. commercial nuclear waste from power generation, research, or medical use) undergoes chemical separation 501. Some long half life waste 502 not suitable for treatment is transferred to long term storage. Other waste is included in target 12, which is bombarded with ions from ion beam generator 11. In some embodiments, waste in target 12 is transmuted into a relatively short half life product 504 which undergoes decay 505 to become a stable product 506, which may be easily disposed of. In some embodiments, waste in target 12 is transmuted to usable fuel 507, and is thereby recycled.

FIG. 1C shows a system for medical treatment. Ion beam generator 11 generates an ion beam which is directed by probe 600 to human or animal body 601 in order to treat tissue in the body. For example, in some embodiments, the ion beam is directed to a tumor 602 in body 601. Some embodiments include producing accelerated particles useful in treating interior tumors and the like wherein the particles (such as H⁺, He⁺⁺, C⁺⁴, C⁺⁶, or O⁺⁸) loose energy very slowly until at a certain energy state, substantially all of the particle's energy is transferred to the tumor.

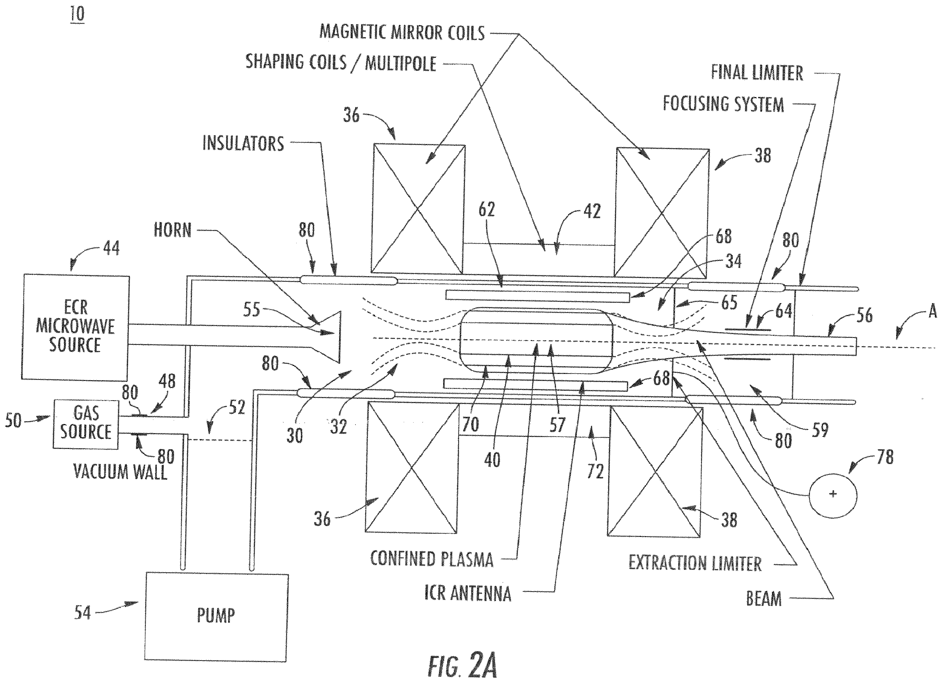

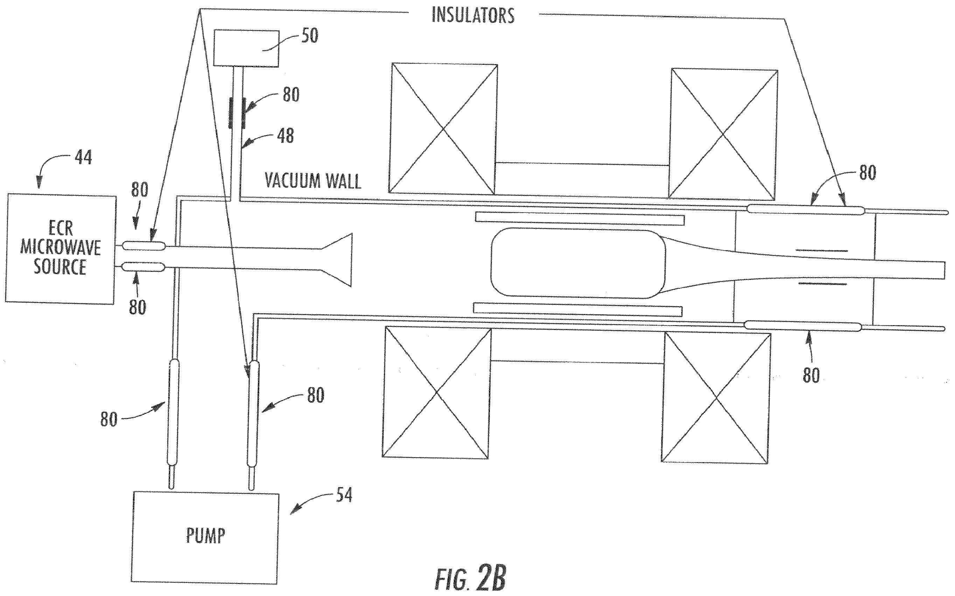

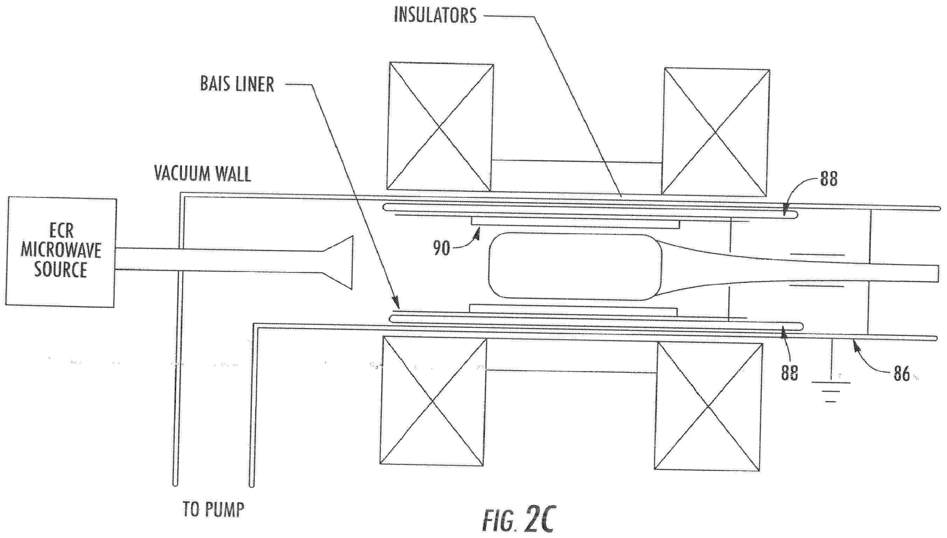

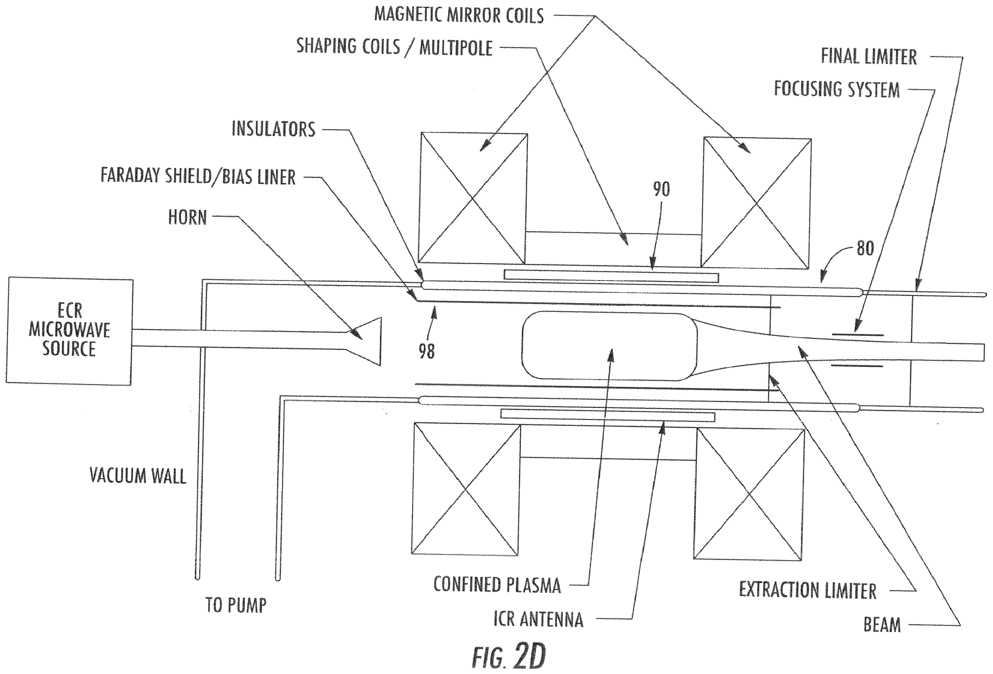

FIGS. 2A, 2B, 2C, and 2D are operational diagrams of ion producing systems using Helium (He) ions as an example. In order to understand the operation of the devices described herein, it is helpful to understand the issues in generating multiple charged ions. Although the ionization of helium is discussed, the basic conclusions apply to all atoms, even including hydrogen (H) and deuterium (²H) where a single electron is striped from the atom to produce a proton (p) or deuteron (d), respectively.

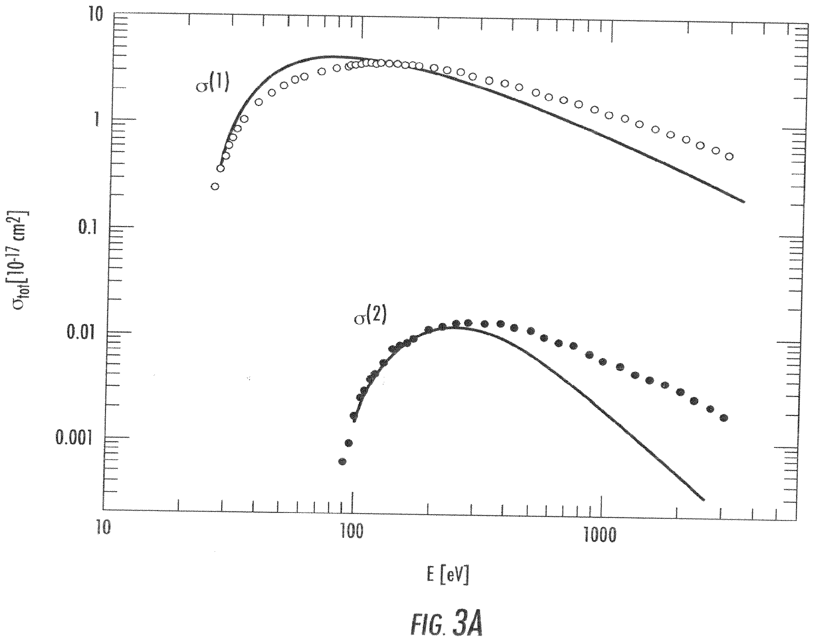

If an ion source uses electron impact to ionize neutral atoms, the ratio of charge states formed can be determined by the cross sections involved. In the case of helium, the cross section for production of He⁺⁺ is more than two orders of magnitude below the cross section for the production of He⁺ (see FIG. 3A). In general, prior art ionization processes produce around 1% He⁺⁺ and 99% He⁺.

Changing the electron impact energy does not make a significant change in the production of He⁺⁺. The best overall performance is obtained near the peak of the He⁺⁺ cross section, approximately 300 eV. Using saturation of states and some other known tricks, it is possible to generate a few percent He⁺⁺ with prior art devices.

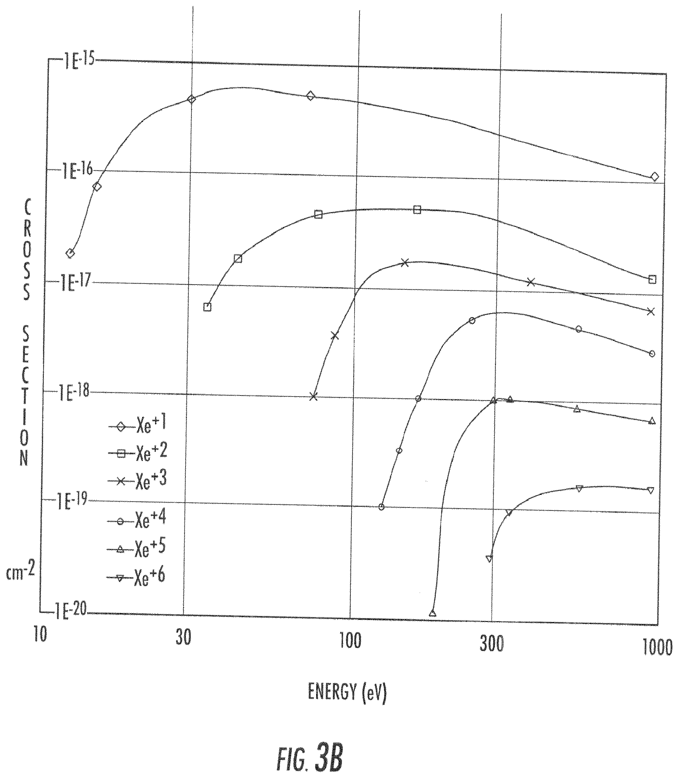

For generating highly ionized states of any other atom, the problem is made more difficult, by introducing more charge states, a greater variation in the cross sections, and more dependence of the cross sections on the electron energy. This can be seen in Fig. 3B, where the electron impact ionization for the first seven states of xenon (Xe) are shown.

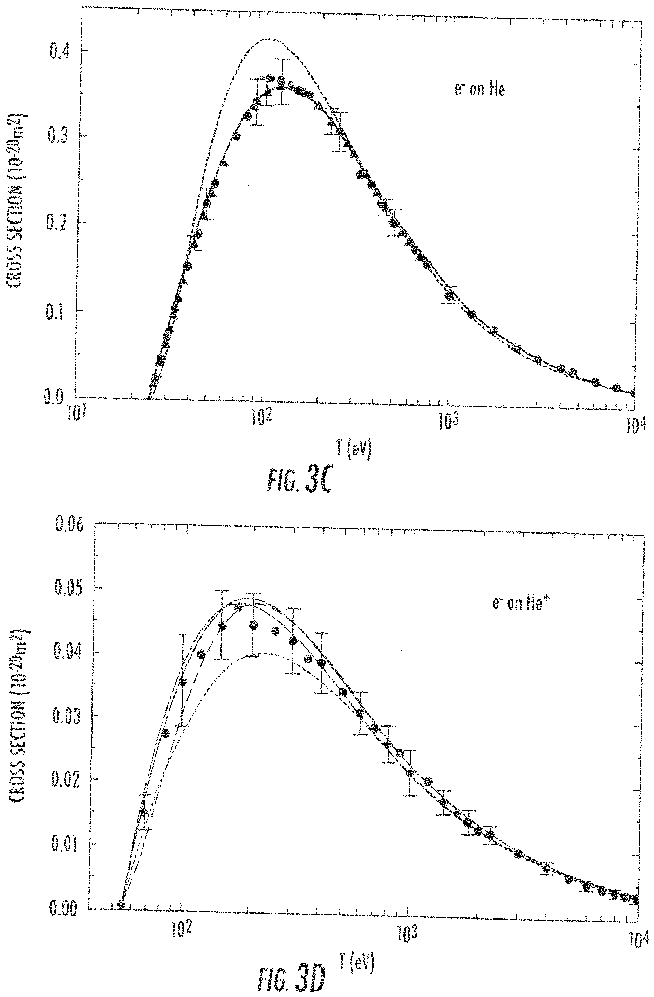

It is difficult to obtain He⁺⁺ with a single electron collision. If more then one electron collision is used, the fraction of He⁺⁺ can be increased greatly because the cross section for production of He⁺⁺ from He⁺ is significantly higher than for the direct production of He⁺⁺ from neutral He (see FIGS. 3C and 3D).

Table I summarizes the different reactions for helium.

**Table I**

| | | |
|---|---|---|
| He + e⁻ → He⁺ + 2e⁻ | 0.35×10⁻¹⁶ | 120 |
| He⁺ + e⁻ → He⁺⁺ + 2e⁻ | 0.045×10⁻¹⁶ | 200 |
| He + e⁻ → He⁺⁺ + 3e⁻ | 0.001×10⁻¹⁶ | 300 |

In order to ionize atoms by multiple collisions to reach a selected final ionization state, it is necessary to confine the intermediate states long enough for them to undergo additional electron collisions. In the case of helium, where He⁺⁺ is the selected final ionization state, it is necessary to confine the He⁺ long enough for it to undergo a second ionizing collision to form He⁺⁺. In the case of other atoms, it is necessary to retain the ion long enough for it to undergo several ionizing collisions to reach the selected state of ionization.

The systems described herein use a confining magnetic field to retain the ions for the time required to reach the selected ionization state. In some embodiments, an azimuthally symmetric axial minimum magnetic field configuration is used. In other embodiments, a "true" minimum magnetic field configuration is used. For production of many ion charge states (e.g. He⁺⁺) the simpler axial minimum field configuration seems to be adequate. For production of highly charged states of some atoms, a "true" minimum magnetic field may be necessary.

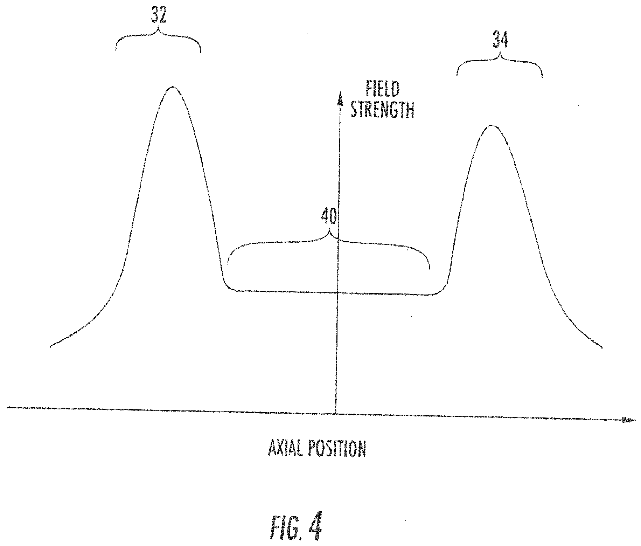

Fig. 2A shows an exemplary ion source 10. Ionization chamber 30 is arranged along longitudinal axis A. Within the ionization chamber 30, a local axial minimum magnetic field is formed between two magnetic mirror fields 32 and 34 (field lines indicated with dashed lines), preferably generated by superconducting magnets 36 and 38. The local axial minimum field is formed as central region of lower, substantially uniform magnetic field 40, (field lines indicated with dashed lines). Fig. 4 shows a plot of the magnitude of the fields 32, 34, and 40 as a function of position along axis A for an exemplary field configuration.

As will be described in detail below, uniform field region 40 provides several beneficial effects which allow for the efficient production of intense ion beams of ions in a selected, multiply ionized state. In embodiments featuring axial minimum configurations, mirror fields 32, 34 and central field 40 may each be azimuthally symmetric about axis A.

Referring back to Fig, 2A, although superconducting magnets are used in some embodiments, they are not required for production of the mirror fields 32 and 34 in every instance. In some embodiments, the coils of superconducting magnets are easier to adjust as the diameter of the wire can be smaller, leaving more room for field adjustment. Refrigeration systems, not shown, for superconducting magnets are commercially available.

The central magnetic field 40 can be implemented using a central magnet 42, which may include copper coils, superconducting coils, and/or fixed magnets. Magnet 42 includes a multi-pole magnet used to generate a "true" minimum field configuration (as described below). In some embodiments, this may be implemented using fixed magnets, although electromagnets or other magnets could be used. A superconducting central magnet 42 is convenient when superconducting magnets 36 and 38 are used, since the area must be cooled close to absolute zero.

Exciter system 44 excites the electron cyclotron resonance of electrons in chamber 40. In some embodiments, to produce ECR excitation, the exciter system 44 introduces microwave energy into the ionization chamber 30 directly.

According to the invention, the center field magnetic region 40 between the two magnetic mirror fields 32 and 34 is substantially uniform (constant magnetic field) although a non-uniform magnetic field will operate. Preferably, the rear part 47 of the ionization chamber 30 includes a connection 48 to a gas source 50, when a gas to be ionized is introduced into the system. In other embodiments, the gas can be introduced anywhere a convenient connection can be made. A perforated plate 52 separates the chamber 30 from a vacuum pump 54 to maintain a slight gas pressure within the chamber 30 and produce a beam 56 of the desired ions from the plasma 57 confined between mirror fields 32 and 34.

The ECR exciter system 44 provides an electric field that couples to the electron cyclotron motion of electrons in chamber 30. Since the electron cyclotron frequency is generally high, the ECR drive tends to be in the microwave frequencies. For these frequencies, wave guides provide the most efficient coupling. ECR coupling, however, is not limited to wave guides, and can be accomplished in other ways, such as cavity mode excitation, optical drive, etc.

If a gyrotron, or other circular wave guide device, is used as an ECR source, good performance will typically be obtained when the rotation direction of the wave within the wave guide is matched to the rotation direction of the electrons in the magnetic field 40. The position of the ECR drive output 55 and gas feed 48 can be optimized so that plasma is primarily produced between the two magnetic mirror fields 32 and 34. In some embodiments, this increases the overall efficiency and minimizes the plasma production in the rear part 47 of the chamber 30, which can simplify the microwave feed system.

The frequency and power in the ECR drive system 44 are related to the plasma density produced. Higher frequency and power both typically correspond to a higher plasma density. The optimal power and type of ECR source may be adjusted for each type of ion.

The substantially uniform central magnetic field 40 between the two magnetic mirrors 32 and 34 will operate for a wide range of lengths. The optimal length may be readily determined experimentally for each ion, selected final ionization state, beam intensity, beam pulse length, and ECR power. Increasing the length of the central magnetic region 40 increases the region over which hot electrons are confined, and thus increases the potential for ionizing collisions. Making this region larger increases the ionization, but at the expense of increasing the time it takes to form a stable plasma. Optimally, a pair of superconducting magnets 36 and 38 are used. Such magnets may not allow for significant variations in the length of the magnetic field 40, because they are not easily relocated. For production of He⁺⁺, this is typically not an issue. But for production of other highly charged ions, more easily movable magnets may be used to allow adjustment the magnetic fields.

In some embodiments, the central magnetic field 40 is chosen to match the ECR frequency of the microwave source 44. The exact values of the mirror fields 32 and 34 are not critical to the operation of the system 10, but may have a large impact on system efficiency. According to the invention, the rear mirror field 32 is higher then the front mirror field 34 (e.g. as shown in Fig. 4). A beam may be formed by allowing ions to leak out of the mirror fields 32 and 34. By making the rear mirror field 32 higher than the front mirror field 34, most of the ion losses, which form the multiply ionized particle beam 56, are through the front mirror field 34. In other embodiments, which are not part of the present invention, mirror fields 32 and 34 may be of equal or substantially equal strength.

The exact value of the front magnetic mirror field 34 can be chosen from a wide range of values, and is generally close to a value of twice the central field 40. In other embodiments it may be three, four, five, or more times that of the central field. Using a higher value of the front field 34 increases the confinement of the ions and electrons, but can cause instabilities in the flow of the plasma 57. Using a lower value field decreases the fraction of ions trapped between the mirror fields 32 and 34. The optimum value depends on the ion, charge state, gas pressure, beam intensity, and ECR power. The exact values may be determined experimentally in each instance.

In order to understand the operation of the system 10, it is helpful to understand how a magnetic mirror 32 or 34 works. Magnetic mirroring occurs when a charged particle moves from a region of low magnetic field to a region of high magnetic field. The magnetic moment of the particle is an adiabatic invariant of the motion: $μ ≡ \frac{{mν}_{⊥}^{2}}{2 B}$

An adiabatic invariant remains invariant so long as the rate of change of the parameters is "slow". "Slow", means that the magnetic field and the perpendicular velocity change slowly over one cyclotron period. In typical embodiments of the magnetic mirrors described herein, this is generally an excellent approximation, except possibly during extraction of the beam 56. The invariance of the magnetic moment indicates that if the particle moves from a region of small magnetic field to a region of large magnetic field, the perpendicular velocity must increase. By conservation of energy, this means that the parallel velocity must decrease. Thus, if a particle with a given perpendicular velocity moves from a region of low magnetic field to a region of sufficiently high magnetic field, the parallel (axial) velocity will go to zero, thereby stopping the particle. As is familiar to those skilled in the art, a more through analysis of the particle dynamics shows that, in fact the particle will be reflected.

By combining the magnetic moment invariant with the conservation of energy, $E = \frac{1}{2} {mν}_{⊥}^{2} + \frac{1}{2} {mν}_{∥}^{2}$ a simple set of equations governing the flow of a particle from magnetic field B₁ to magnetic field B₂ can be derived: ${ν}_{⊥ 2}^{2} = {ν}_{⊥ 1}^{2} \frac{{B}_{2}}{{B}_{1}}$ ${ν}_{∥ 2}^{2} = {ν}_{∥ 1}^{2} + {ν}_{⊥ 1}^{2} \left(1-\frac{{B}_{2}}{{B}_{1}}\right)$

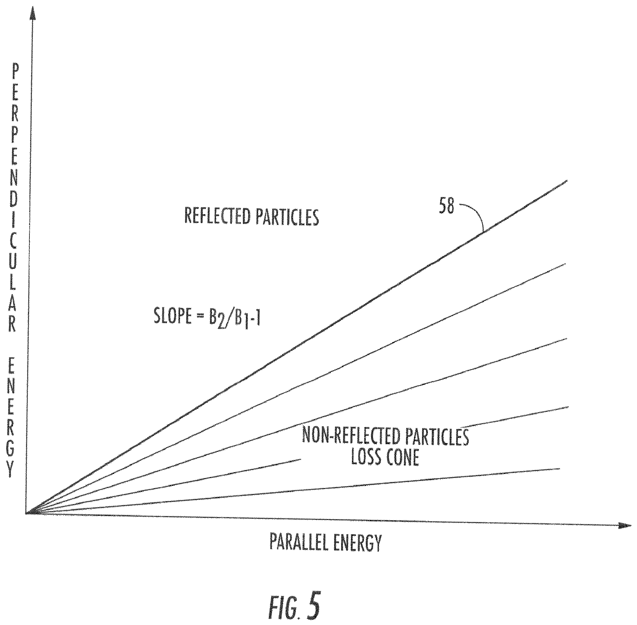

When a particle travels from a low magnetic field to a high magnetic field, the second term in the parallel velocity equation can be negative. If it is sufficiently negative the particle will stop and be reflected. Therefore, if particles are moving from one magnetic field to another, the reflection depends on the ratio of the perpendicular to parallel velocity of the particle. Specifically, the particle will be reflected at some point when: $\frac{{ν}_{\left‖1\right.}^{2}}{{ν}_{⊥ 1}^{2}} < \left(\frac{{B}_{2}}{{B}_{1}}-1\right)$ the non-reflected particles can be visualized as a cone 58 in velocity space, as shown in Fig. 5.

Generally magnetic mirrors fields, such as magnetic mirror fields 32 and 34 leak. Particles in the loss cone 58 leak out of the front mirror field 34 (or the back mirror field 32). Particles that are not in the loss cone 58 are eventually scattered into the loss cone 58. The systems described herein, in various embodiments, rely on this scattering to move the particles into the loss cone 58 that will then pass through the front magnetic mirror field 34 and form a source of ions.

Referring back to Fig. 2A, during source operation microwaves are used to excite the ECR in the central region 40 in chamber 30 of the source. This generates hot electrons that ionize the background gas. For He⁺⁺ production, the preferred electron energy is around 200-300 eV. For other atoms, the preferred electron energy may easily be experimentally determined by the energy required to produce the desired charge state and/or the peak of the cross sections involved.

Considering first the production of alpha particles (He⁺⁺) the hot electrons generate mostly He⁺ and some small amount of He⁺⁺. Some of the generated He⁺ is trapped between the magnetic mirror fields 32 and 34 and undergoes a second collision forming He⁺⁺. Gradually, the He⁺⁺ and He⁺ are scattered into the loss cone 58 where they leak out, primarily through the front mirror field 34, forming the beam 56 of He⁺ and He⁺⁺. Generally the description focuses around alpha particles (⁴He⁺⁺), but the same discussions apply equally to helium-3 ions (³He⁺⁺) or other doubly ionized ions.

The plasma beam 56 of He⁺ and He⁺⁺ in a ratio (determined as the ratio of the beam current of He⁺⁺ to total beam current) of up to 84% He⁺⁺ or more leaking from the front mirror field 34 is producible using an ECR system 44 only, is accelerated by a extractor 59 which may include a sequence of electrodes and focusing elements to form the particle beam 56. In cases where it is desirable to transmit the beam 56 to a magnetic field free region, the extraction system can be designed to make sure that particles remain adiabatic until the particles are out of the magnetic field 34.

If the plasma flow out of the magnetic field zone remains adiabatic, the mirror relations can be applied. As the particles travel from the high magnetic field to the low magnetic field, perpendicular energy is converted to axial (parallel) energy. This keeps the emittance of the beam 56 low during the particle extraction. A non-adiabatic extraction of the beam 56 results in perpendicular energy of the beam 56 being retained and the extracted beam 56 has larger emittance.

There are four known major sources of particle losses in the plasma system 60 of the present invention. These are: recombination, charge exchange, radial diffusion, and loss cone scattering (axial diffusion).

In typical embodiments, Recombination is not a significant effect. Generally, the electrons in the plasma system 57 are at a very high energy. As a new electron is liberated in an ionizing collision, it rapidly gains energy. Therefore, recombination between the energetic electrons and the ions is not significant.

Charge exchange affects only the multiply charged ions. If an electron is transferred from He to He⁺, the result is the same number and composition of ions, that is, the He becomes He⁺ and the He⁺ becomes He. If an electron is transferred from He to He⁺⁺, however, the result is two He⁺ ions, so a He⁺⁺ ion was lost. In the case of the devices described herein, the ion energy can be sufficiently low that charge exchange is not a significant problem.

Radial diffusion is not an issue if the central magnetic field 40 is large. If the cyclotron orbit of an ion is small compared with the size of the ionization chamber 30, radial diffusion is very slow and particles are scattered into the loss cone 58 faster than they diffuse radially.

In typical embodiments, scattering into the loss cone 58 is the primary loss method for particles. The system 10 requires this scattering process in order to generate the beam 56 from the plasma 57. Loss cone scattering of He⁺⁺ is desirable as this forms the extracted ion beam 56. Loss cone scattering of He⁺, however, is not desirable as it causes He⁺ to enter the beam 56, thus increasing the percentage amount of He⁺ in the beam 56. He⁺ ions in the beam 56 can be separated from the He⁺⁺ ions using a mass ion filter 61, but this decreases the beam intensity, increases the emittance, and decreases the overall beam efficiency.

The hot electrons generated by the ECR source 44 have a non-isotropic distribution, with the perpendicular energy being much larger then the axial energy. Ions generated by the collisions with the electrons also have a non-isotropic distribution with more of the energy perpendicular to the magnetic field 40 than parallel. Given a mirror ratio near 2 (Bₘᵢᵣᵣₒᵣ/B_{central}), somewhat more than half the formed He⁺ is confined by the mirror fields 32 and 34, and somewhat less than half the He⁺ is not confined and leaves the mirror fields 32 and 34 on the first pass. Some of the initially unconfined particles exit from the rear mirror field 32 and the rest exit from the front mirror field 34. Depending on the particle densities and temperatures, geometric considerations, and some other parameters, the produced beam 56 will typically be between 50-90% He⁺⁺ and 50-10% He⁺. The exact ratio of He⁺ to He⁺⁺ in the generated beam 59 depends on a complicated set of relations between gas density, ECR power, source geometry, and magnetic field geometry. The exact ratio can be determined experimentally and optimized to produce a desired beam ratio 56. As noted above, beam ratios of 84% or greater have been experimentally demonstrated using devices of the types described herein.

The ratio of highly multiply ionized particles can be increased by using an ICR (Ion Cyclotron Resonance) exciter system 62, although for He⁺⁺, it may not be needed. This system 62 uses antennae 68 in the chamber 30 between the mirror fields 32 and 34 to emit at the radiation proper frequency to couple energy into the ion cyclotron resonance of He⁺ ions, thus coupling energy into the perpendicular motion of the He⁺ ions. In general, the axial (parallel) velocity of the particles remains unchanged by ICR excitation. Increasing the perpendicular energy pushes the driven particles out of the loss cone 58. In some embodiments, by using ICR excitation, the scattering rate of He⁺ into the loss cone 58 can be reduced to nearly zero.

In reality, the He⁺ ions cannot be kept out of the loss cone 58 indefinitely. Given sufficient time, particles will be scattered into the loss cone 58. This scattering basically is converting some of the particle's perpendicular energy into parallel energy. The ICR excitation can then add more perpendicular velocity and push the particle back out of the loss cone 58 again, but eventually, the parallel energy will get sufficiently high that the particle will escape the mirror fields 32 and 34.

The goal is not to keep ions out of the loss cone 58 indefinitely, but rather just long enough to undergo a multiple ionizing collisions. When the system 10 is operated at a high plasma density, these multiple ionizing collisions occur faster than scattering into the loss cone 58.

According to the invention, the ICR excitation is used and the system 10 operates as follows.

Microwaves excite the ECR in the central magnetic region 40 of the chamber 30, which generates hot electrons. These electrons ionize the background helium gas producing mostly He⁺ ions, but also some He⁺⁺ ions. The ICR system 62 excites the He⁺ resonance in the central magnetic region 40. The He⁺ ions are trapped between the two magnetic mirror fields 32 and 34 where a second collision with an electron causes a second ionization to produce He⁺⁺. The ICR excitation does not couple to the He⁺⁺ ions, which have twice the cyclotron frequency. The He⁺⁺ ions are scattered into the loss cone 58 where they exit the chamber 30 as the ion beam 56.

According to the invention, most of the He⁺⁺ exits via the front mirror field 34, which is lower. In some embodiments, the height of the back mirror field 32 should be as high as possible, or at least higher than the front mirror field 34. However, system 10 may operate even when front mirror field 32 is equal to or substantially equal to back mirror field 34

In some embodiments, the ICR excitation causes the density of the plasma to increase until losses balance production. In the limit, where the ICR exciter 62 can hold the He⁺ out of the loss cone 58 indefinitely, the plasma density will increase until the production of He⁺ is equal to production of He⁺⁺, which equals the rate that He⁺⁺ is scattered into the loss cone 58.

Most of the above examples have focused on helium. Helium has only two charge states so it is easy to see how system 10 can produce a high density ion beam 56 of He⁺⁺. The same technique can also be used to produce multiply ionized ions in a selected final ionization state of almost any other atom, especially when the ICR system 62 is used. However, when working with other atoms (e.g. those with more than two ionization states), several issues are notable.

First, depending on the ionization state and the atom required, it may be necessary to increase the electron energy of the ECR heated electrons. This can be done by increasing the power in the ECR source 44 and/or by decreasing the cooling effects on the electrons. Under the correct conditions one may obtain electron energies as high as 600 to 1000 keV. In order to obtain very high electron temperatures, it may be necessary or desirable to add a radially confining multipole field to the center region 70 of the magnet system, creating a "true" minimum magnetic field configuration. According to the invention, a radially confining multipole magnet 72 (e.g. a hexapole, or higher order multipole magnet) is be used. This has some real advantages with the ICR exciter system 62 whcih is used. As described in more detail below, the higher order multipole magnet 72 localizes the field effects to the outer radial edge of the plasma 57 and leaves the central part of the plasma 57 (located proximal to axis A) unaffected. The "true" minimum magnetic field configuration provides a form of insulation between the plasma 57 and the wall 76 of the chamber 30 and makes it easier to obtain high temperature electrons.

Second, if the ICR exciter system 62 is used, there is a question of what ICR frequency to use. When there are several ionization charge states available, so there will be several potential ICR exciter frequencies: $\frac{1 eB}{M} , \frac{2 eB}{M} , \frac{3 eB}{M} , \frac{4 eB}{M} , ⋯ ⋯$

In some embodiments, one frequency is chosen for excitation. Generally, exciting the lowest ionization state provides the most increase in production of any higher states. It is also possible to excite multiple states, or all states. For example if the desire was to produce O⁺⁸, useful in treating inoperable tumors, an ICR excitation system could be provided with multiple antennae that excite the ICR resonances of O⁺, O⁺⁺, O⁺³, O⁺⁴, O⁺⁵, O⁺⁶, and O⁺⁷, thus preferentially holding all oxygen ions other than O⁺⁸ within the chamber 30.

The system 10 includes a positive source 78 to bias the chamber 30 at high potential in order to accelerate the ions extracted. Therefore a number of insulators 80 are necessary to allow the system 20 to be biased at different voltages and to electrically isolate the chamber 30 to provide operator safety.

There are a number of different ways to implement insulator systems. These include, but are not limited to the embodiments of system 10 shown in of FIGS 2A, 2B, 2C, and 2D. The configurations shown in FIGS 2A and 2B are just variations of each other with insulators 80 used to electrically isolate the vacuum pump 54, the ECR source 44 and the atom source 50. The system shown in FIG 2C is significantly different in that the entire outer wall 86 of the chamber 30 is biased at ground. An internal bias liner 88 is used to control the plasma bias and thus the extraction energy of the ions. In terms of fabrication, in some embodiments this may be somewhat more complicated, but may provide greater operator safety in that it is more difficult for an operator to come in contact with the high voltage. With an inner bias liner 88, the liner 88 could be placed either inside or outside of the ICR antenna 90. In some cases, it may be possible to use the ICR antenna 90 itself as a bias liner 88, but if the bias liner 88 is placed inside the ICR antenna 90, it must contain at least one slit to prevent shorting out the ICR drive.

Fig. 2D shows a variation of system 10 using a non-conducing vacuum wall 80 where the ICR antenna 90 external to the vacuum system. A Faraday shield 98 is used as a bias liner inside the vacuum system.

An external antenna design can be generalized to work with most antennas. In most cases an insulating chamber wall can be used. The antenna system can be located external to the vacuum system. A bias liner containing slit(s) can be used inside the chamber to control the plasma bias without interfering with the ICR excitation.

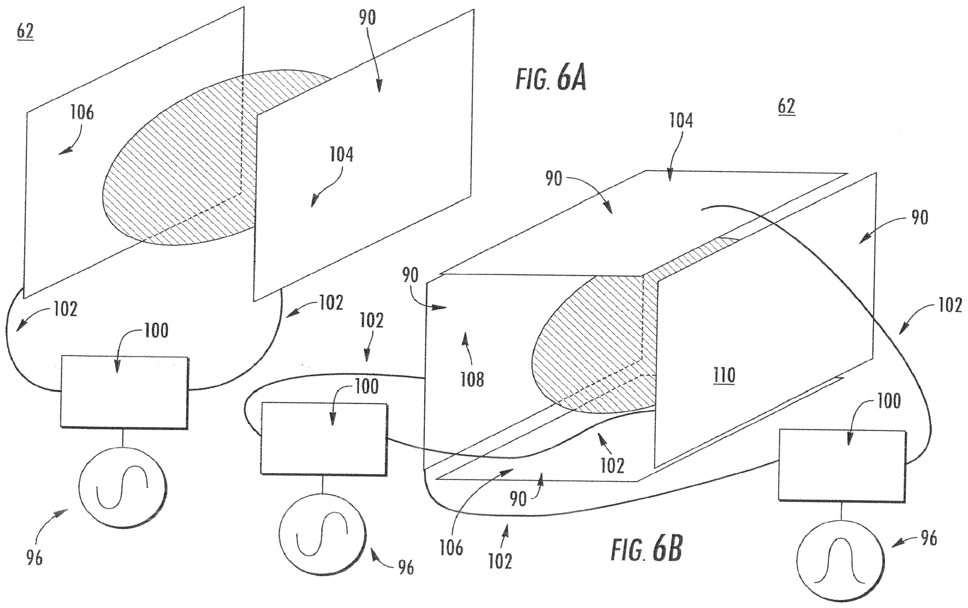

As shown in FIGS. 6A and 6B, an ICR exciter system 62 includes an RF drive system 96, an antenna 90, and a tuning system 100. The goal is to generate an electric field that will couple to the ion cyclotron motion. An electric field rotating in the same direction as the ions provides the highest coupling, but other combinations such as linear or radial electric fields also work. Generally the ICR frequencies are in the RF range and the antenna 90 is fed from coaxial lines 102. A capacitor/inductor network normally is used within the tuning system 100 to match the antenna 90 with the driver system 96. In typical embodiments, the magnetic field in the region where the ICR exciter is applied should be relatively constant so that the cyclotron frequency of the ions is well defined. Central uniform field region 40 meets this requirement. Depending on how the antenna 90 is implemented and how the insulator system is implemented, the antenna 90 may be at high voltage. Coupling between the antenna 90 and RF drive system 96 can be provided using a transformer or capacitors in order to provide isolation between the systems.

A number of different antenna systems such as antennae 90, can be used for the ICR exciter 62 These include, but are not limited to: cavity excitation, capacitor plates, split-ring, and filer. Cavity excitation simply couples to the cavity mode of the chamber 30 using a loop (not shown) or some other type of exciter.

The optimal antenna design may depend strongly on the specific ion and charge state desired. For production of multiply charged ions other than doubly charged ones, it may be desirable to drive the antennae at multiple frequencies.

Capacitor plate antennas can be either linear (FIG. 6A) or circular drive (FIG. 6B). In the case of linear drive the two plates 104 and 106 are driven to generate an oscillating electric field. In the case of a circular drive, vertical plates 108 and 110 are driven 90° out of phase with the horizontal plates 104 and 106, generating a rotating electric field. In other embodiments, other phase angles may be used, thereby generating elliptical drive radiation. Note also that although the terms vertical and horizontal are used here for convenience to describe the relative positioning of the plates, the antenna plates may be oriented arbitrarily in chamber 30. The exact structure of the plates is unimportant, other than that they provide an electric field perpendicular to the magnetic field 40. In some embodiments, capacitor plate antenna (or other antenna type) may be used in exciter system 62 to produce output at multiple frequencies

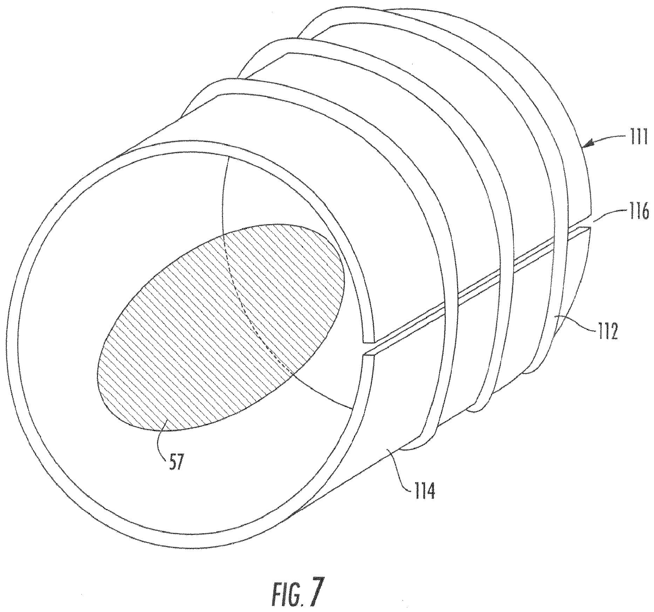

Referring to FIG. 7, a split-ring antenna 111 consists of a coil of wire (or tubing to allow cooling) 112 wrapped around a Faraday shield 114. The Faraday shield 114 prevents the helical electric field of the coil 112 from reaching the plasma 57. The lengthwise slit 116 in the metal of the Faraday shield 114 allows a mostly linear component of the electric field to reach the plasma 57, which couples to the ion cyclotron resonance. The actual electric field is more like radial arcs coming from the slit 116, but this couples to ion motion with about the same efficiency as a linear drive system.

In cases where an internal bias liner is used, e.g. as shown in FIG 2C, it is possible to use the Faraday shield 114 as a bias liner inside the ICR exciter system 62. A variation of this arrangement, as shown in FIG. 2D, is to use a non-conducing vacuum wall insulator 80 and place the ICR antenna external to the chamber 30, and use the Faraday shield 98 as a bias liner inside the chamber 30.

An external antenna design can be generalized to work in most configurations. In most cases, the chamber 30 can include an insulating chamber wall 80 so that the ICR antenna 68 can be located in a region of ambient pressure, outside of the chamber 30. A bias liner 98 containing one or more slits 116 (as shown in FIG. 7) can be used inside the chamber 30 to control the plasma bias without interfering with the ICR excitation.

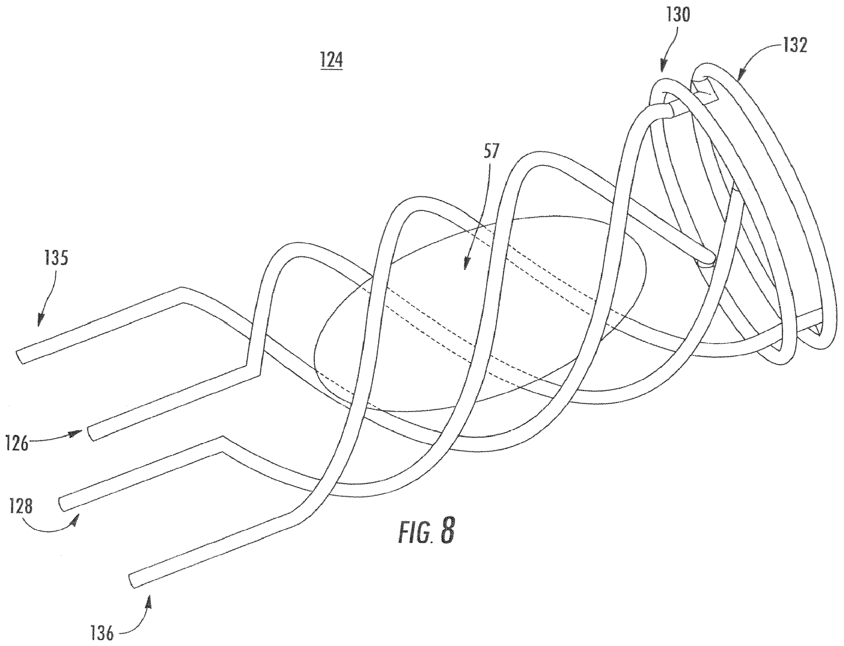

Referring to FIG. 8, a filer antenna 124 contains a number of helical conductors, 126 and 128 shown, in which currents are driven. Depending on the type of filer, either a linear drive field or a rotating (i.e. circular or elliptical) drive field is generated. For a rotating drive field, as shown, there are actually two filers 130 and 132 that are constructed perpendicular to each other having helical conductors 126 and 128, and 135 and 136. The two filers are driven 90° out of phase to generate a rotating electric field. A simple filer antenna would have only one of the two filers 130 or 132.

In addition to the other variations in the ICR antenna systems 60 discussed above (cavity excitation, capacitor plates, split-ring, and filer) an untwisted filer antenna 140 can be used. As shown, untwisted filer antenna includes two filers 141 and 142. In some embodiments a singe untwisted filer may be used. In this case, one of filers 141 and 142 would be omitted.

The bi-filer antenna 124 is basically a twisted set of current carrying wires. The wires on opposite sides of the plasma 57 carry current in opposite directions. These wires combine to generate a magnetic field in the center of the plasma 57. As the current oscillates, the generated magnetic field oscillates, and induces an electric field in the center of the plasma 57. A single filer antenna generates a linearly polarized excitation and the bi-filer antenna typically generates a rotating excitation field (circularly or elliptically polarized). Generally inductive antenna systems (such as the filers) have advantages over electrostatic antennas (such as capacitor plates). This is because the high density plasma 57 tends to screen out the electric field generated by electrostatic antennas, thus such antennae primarily couple to the plasma 57 only at the outer edge of the plasma 57. Inductive antennae drive though an induced electric field that is generated by an oscillating magnetic field. The magnetic field can pass through the plasma 57 and thus the drive field is located everywhere in the plasma 57, and generally is peaked on the axis of the chamber 30.

Typically a filer antenna 124 has a twist in it to prevent charge separation in the plasma 57. In the present invention, the twist is not needed. The short length of the source allows the particles at the end of the plasma 57, where the drive field is weak, to provide neutralization, thus charge separation is not a large problem. Further neutralization is provided by plasma rotation, which prevents the antenna, such as bi-filer 124, from driving only over one part of the plasma 57. The plasma rotation is due to the slight non-uniformity of the plasma 57 as ions and electrons are lost at slightly different rates, resulting in a slight charge imbalance that equalizes these two loss rates (ambipolar potential). This charge imbalance gives rise to a radial electric field, which combined with the axial magnetic field gives rise to plasma rotation.

The untwisted-filer antenna 140 has advantages that it will couple to the ions going both directions in the source. The twisted-filter antenna imposes a Doppler shift on the ICR drive field. This means the drive field couples to particles with a cyclotron frequency given by *ω* ± *k_{z}v_{z}* (where the sign is determined by the direction of the antenna twist relative to the direction of ion cyclotron rotation, and k_{z} is determined by the structure of the filer). The twisted-filer can be matched to particles going one direction in the device (say positive-z), but not the other direction, since the sign of the axial velocity will change. The untwisted-filer has k_{z}=0, thus it will couple to particles going both directions in the device. This allows the ICR exciter to couple to more of the plasma.

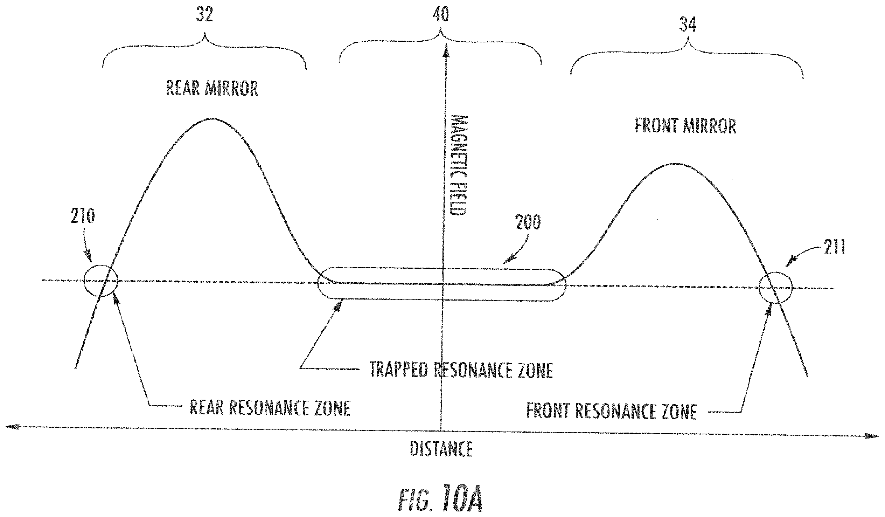

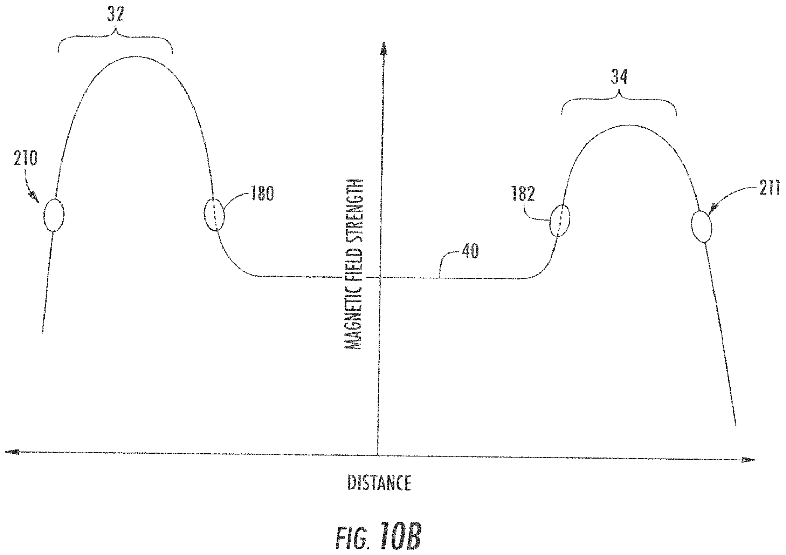

Referring to FIGS. 10A and 10B, system 10 may be operated in resonant (FIG. 10A) or sub resonant (FIG. 10B) ECR modes. In the resonant mode, ECR source 44 produces microwaves are resonant with the ECR motion of electrons the uniform field 40 (resonant zone 200 located between the two mirrors fields 32 and 34 as shown in FIG. 10A). This zone corresponds to a cylindrical volume about axis A in region 70 of chamber 30. This arrangement provides the highest coupling between the electrons and the microwaves.

The general requirements on the uniformity of the central field for the resonant mode can be expressed as a relation between the electron confinement time and the electron de-correlation time. If an electron is placed in a uniform magnetic field it will orbit about the field with the cyclotron frequency given by ${ω}_{ce} = \frac{eB}{m} .$

If the electron motion is driven by an ECR drive generating a rotating electric field that rotates in the same direction as the electron, the electron can gain energy. If the drive frequency (ω_{ECR}) exactly matches the electron cyclotron frequency the electron will continue to gain energy until relativistic corrections to the electron motion become significant. In typical embodiments this is not a significant issue as relativistic corrections will be come significant when the electron energy becomes a significant fraction of the electron rest energy. (The electron rest energy is 512 keV and, for many embodiments, target electron energies are 200-300 eV for alpha particle production, and about 1 keV for production of C⁶⁺).

If the drive frequency does not exactly match the electron cyclotron frequency, then the electron will first gain energy then loose energy, and then gain it again. In fact, when the electron looses energy it will return to the same initial conditions as before it was accelerated by the ECR drive. The time scale of this loss and gain of energy is given, in terms of the ECR frequency ω_{ECR} by ${τ}_{DC} = \frac{π}{\left|{ω}_{ce}-{ω}_{ECR}\right|} .$

The gain (or loss) of energy of an electron in an off-resonant ECR drive field is also limited by $Δ {K}_{max} \approx \frac{{mξ}^{2}}{2 {\left({ω}_{ce}-{ω}_{ECR}\right)}^{2}}$ where ξ is the normalized electric field eE/m.

In some embodiments, the field is not completely uniform. In such a case, the cyclotron frequency can be replaced with an average cyclotron frequency experienced by the electron. Or more accurately an average value over all the electrons of the average cyclotron frequency experienced by each electron.

Given these conditions we can express a sufficient condition on the uniformity of the field as the de-correlation time must be longer or on the order of the electron confinement time in the device. For the on resonant mode, when this condition is met, the field may be considered to be substantially uniform.

In some embodiments field 40 is uniform to 1% or less, 5% or less, 10% or less over a region extending axially 5 cm, 10 cm, 15 cm, 30 cm or greater, while the mirror-to-mirror distance is 60 cm.

In some cases, operation in the resonant mode may result in too energetic electrons. For example, in the case of formation of He⁺⁺, the peak of the cross sections for all formation methods is between 200-300 eV. Given sufficient power and coupling, electron temperatures well above 10 keV can be generated. These high energy electrons are not useful for the formation of the He⁺⁺, and tend to produce unwanted X-rays. The electron temperature can be controlled by manipulating the microwave power, gas pressure, the length of the resonant zone(s) and electron confinement time.

An alternative system, as shown in FIG. 10B, for controlling the electron temperature is to adjust the magnetic field in the central region 40 such that the ECR drive is detuned from the uniform field 40. This is referred to herein as the sub-resonant mode. This mode restricts the microwave coupling to zones 180 and 182 localized on each end of the chamber 30 adjacent the mirror field zones 32 and 34 (in contrast to the large cylindrical volume in which coupling occurs in resonant mode operation). The lower the central field 40, the smaller these zones 180 and 182 become. This method has the advantage that high microwave power in this configuration corresponds mostly to high electron (and plasma) density and not to high electron temperature. This method can be more efficient for production of low to moderate ionization states (such as He⁺⁺).

In this mode of operation there are two small ECR sections 180 and 182 located between the uniform field region and the magnetic mirrors. Particles are not in these zones long enough for de-correlation to be a significant issue. Electrons pass through the ECR zone, and depending on the phase of the particle relative to the ECR drive phase, the particle will gain or loose some energy in the zone. Because the phase at which the vast majority of electrons encounter both ECR zones is not correlated, they gain or loose energy each time they pass through the ECR zones. This leads to a stochastic heating process (similar to random walk) that leads to the gradual gain of energy (i.e. gradual as comparison to the resonant mode using similar operating parameters). For this process directly there are not requirements on the field uniformity of the central field, but the limitations on plasma stability still apply.

In some embodiments with this configuration the relation between the central field and the ECR frequency is significant. If these two match too closely, then one cannot consider the electrons to leave the ECR zone, and the entire central region appears to be one large ECR zone that is off-resonance. If this is the case the performance of the system is very poor, as the energy gained by the electrons is limited by the relation given above. Further the de-correlation time is short, so the electrons gain and loose energy rapidly leading to poor confinement.

If the central region corresponds to a magnetic field that is sufficiently far from the resonance condition, then the energy that can be gained or lost by an electron crossing the zone is limited by the relations above. Further, if the central region is sufficiently far from the resonant condition, other effects dominate the transit through the central region. This allows the electron phase to be effectively randomized between the two ECR zones. This reduces or eliminates the number of particles that are consistently poorly phased matched between the two zones.

The ICR exciter system 62 can be used as there still will be a uniform magnetic field 40 in the center of the chamber 30, but the ECR zones will be located only adjacent the zones of the mirror fields 32 and 34. In such cases, the ICR frequency is decreased slightly to match the lower resonant field. An added advantage is the mirror ratios on the front and back mirror fields 32 and 34 are increased somewhat as the central field 40' is lowered.

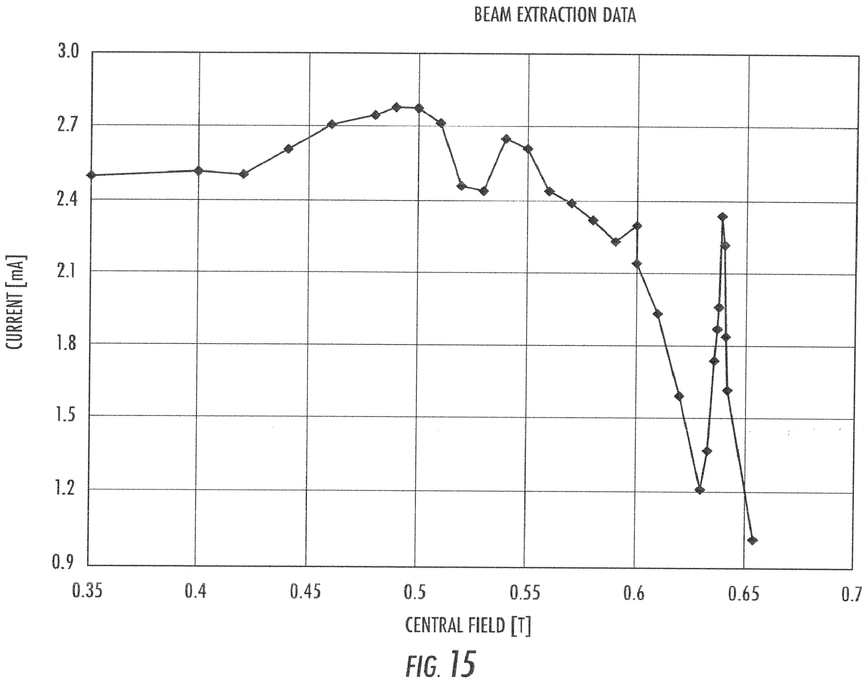

FIG. 15 illustrates both resonant and sub resonant modes of operation. FIG. 15 is a plot of total extracted beam current as a function be central magnetic field (at constant ECR drive frequency of 18 GHz) using small aperture. The sharp peak located at approximately 0.638 T corresponds to resonant mode of operation. The broad flat peak around 0.5 T corresponds to the sub-resonant mode of operation.

Note from the graph it may appear that the sub-critical mode of operation yields more current and thus may be better, but this can be misleading. The data was taken by varying only the central field, thus the mirror ratio, which is strongly tied to plasma production, is not constant across the graph. Also the beam composition is not plotted here so the ratio of He⁺⁺ to He⁺ also varies along the graph.

The region between 0.635 T and 0.56 T, neither mode fully applies. Clearly close of 0.63 T the electron de-correlation time is short, and the maximum energy obtained the electrons is too low for the formation of He⁺⁺. As one approaches the 0.6 T, the ECR zones have moved out from the central region, toward the higher field, but the zones may be too large and too well correlated to lead to an efficient stochastic heating process.

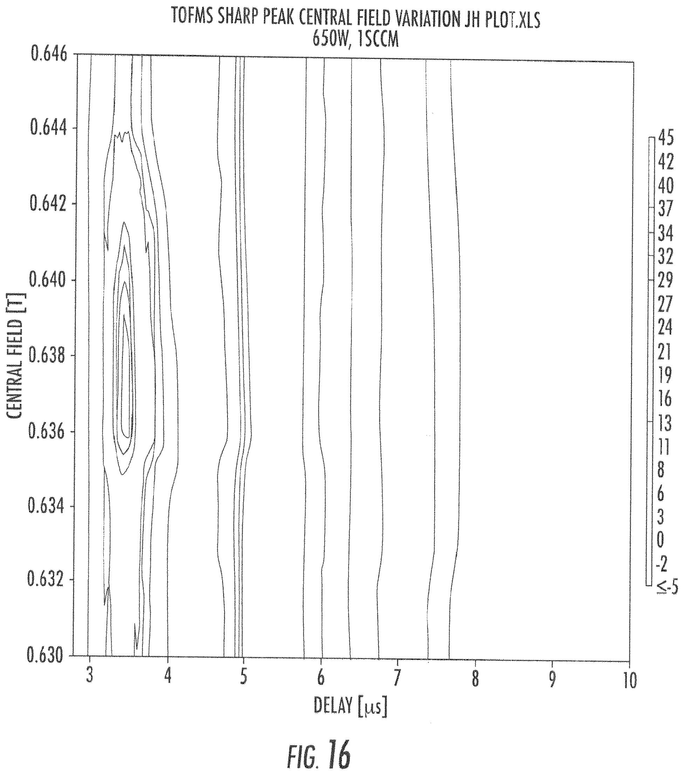

FIG. 16 shows time-of- flight mass spectrometer data for the resonant mode of operation. The horizontal axis represents time; the data near 3.5 µs corresponds to He⁺⁺ and the data near 5.5 µs corresponds to He^{+.} The vertical axis indicates the central magnetic field. Note the He⁺⁺ production is flat between 0.636 T and 0.639 T. This region corresponds to the electron de-correlation time being longer then the electron confinement time so electrons are lost before they can decelerate.

The uniform field region also has another advantage other then just coupling energy to the electrons or ions. In some embodiments, mirror devices are unstable to a number of instabilities driven by the curvature of the magnetic field. In particular, the shape of the field in the region between the uniform field and the magnetic mirror can be very unstable. In this region the combined drift of the particles in the curved magnetic field is given by $\vec{ν} = {\vec{ν}}_{R} + {\vec{ν}}_{∇ B} = \frac{m}{q} \frac{{\vec{R}}_{C} \times \vec{B}}{{R}_{C}^{2} {B}^{2}} \left({ν}_{⊥}^{2}+\frac{1}{2}{ν}_{∥}^{2}\right)$ where R_{C} is the radius of curvature of the magnetic field. These drifts cause ions and electrons to drift in opposite directions. The resulting electric field generated by the change separation gives rise to a radial E×B drift ${\vec{ν}}_{E \times B} = \frac{\vec{E} \times \vec{B}}{{B}^{2}}$ that can lead to radial diffusion. When the magnetic field is curved toward the plasma (concave) the resultant drift causes outward transport and loss of the particles. This is often referred to as "bad" curvature. On the other hand, when the magnetic field is curved away from the plasma (convex) the resultant drift causes inward transport and confinement of particles. This is often referred to as "good" curvature.

In a simple magnetic mirror, the particles spend much more of their time in the regions of "bad" curvature then in the regions with "good" curvature and this leads to rapid radial loss of particles.

In the systems described herein, the uniform field regions greatly increase the stability of the plasma and provide for ion confinement time that is comparable to the time required to remove the second (or more) electron(s) to form ions in the selected final state.

The increased stability is provided by a number of factors. First, the uniform sections have essentially no curvature so they decrease the overall time particles spend in the regions of "bad" curvature. There are thresholds associated with the instabilities that lead to transport. Clearly curved magnetic field driven instabilities will not grow if the average magnitude of the drifts are smaller then thermal transport drifts. Second, the uniform field region contains a large fraction of the plasma. This region provides a charge reservoir that damps out the change separation caused by the curved magnetic field drifts. Basically this allows charge to flow along the axis and neutralize the change separation caused by the "bad" curvature region. Third, the uniform region disconnects the two regions of "bad" curvature. Thus instabilities growing on one end of the device generally cannot couple to instabilities growing on the other side of the device due to inconsistent phase shifting by particles traveling from one side of the device to the other.

In some embodiments, requirements on the field are on the order of 5-10% uniformity over the majority of region 70. Stability may be more of an issue in the sub-critical mode because of the potentially higher mirror fields which reduces the threshold for instabilities.

Referring to FIGS, 14 and 14A, in some embodiments, (e.g. for generation of very highly ionized ion species and/or for generation of very intense ion beams) it may be helpful to add a radial surface confinement magnetic 76 to the system 10. Confinement magnet 76 produces radial confinement field 184 turns the axial minimum field configuration into a more complete minimum field confutation, by adding a generally increasing magnetic field as a function of radius. Note that a true minimum magnetic field configuration cannot be generated (such a static configuration would violate Maxwell's laws). Configurations referenced to in the art as "true" magnetic minimum configurations are just partial minimum magnetic fields. All of these types of configurations contain cusp regions where the field does not increase as a function of radius. The size, shape, and location of these regions distinguish these different minimum magnetic field configurations.

The surface confinement magnetic field increases the confinement time of the electrons in the system 30. This increases the electron density in the system 30, as well as the electron temperature (energy), as the electrons are in the ECR drive field longer. Higher electron density corresponds to more ionizing collisions with neutrals and ions. Higher electron energy corresponds to the ability to generate higher ionization states. This is not useful for He⁺⁺, but could used for creating highly ionized states of other atoms.

In some embodiments, a hexapole fixed magnet system (not shown) is used to generate a "true" minimum magnetic field configuration. The hexapole magnets of alternating polarities create a field that penetrates radially well into the plasma 57, and limits the microwave coupling region, as well as preventing the use of an ICR exciter system, because of the lack of a uniform magnetic field region.

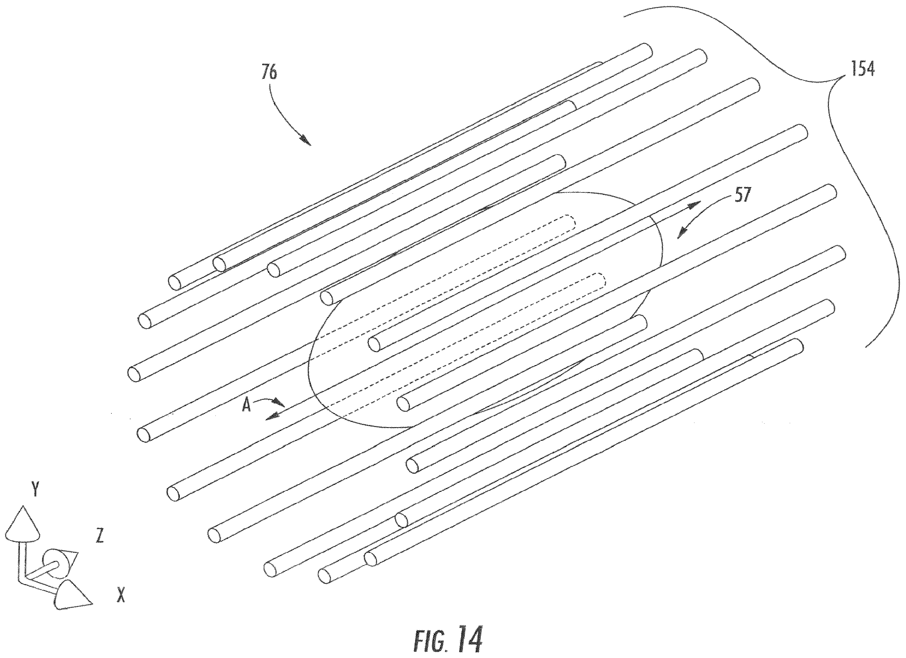

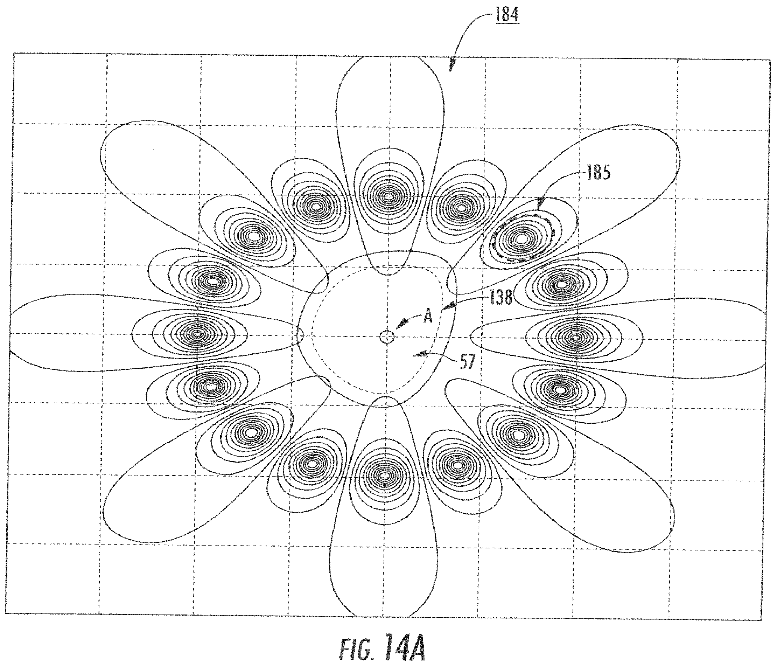

As shown in FIGS. 14 and 14A, a higher order multipole field is used to produce a surface confinement field 184 that would only affect the edges 138 of the plasma 57, allowing for a broad ECR coupling region and use of an ICR exciter. A higher order multipole field can be introduced using fixed magnets, but it can also be introduced using a series of current carrying wires 154, located around the source area. In such a case, each wire 154 would carry current in the opposite direction to the adjacent wire 154, giving rise to an adjustable multipole magnetic field 184. The strength of the current in the wires 154 determines the multipole field 184, which can be quite strong very close to the wires 154, e.g. in region 185. The wires 154 used to generate the multipole field 184 can be twisted or straight (as shown). The same wires 154 can be used to produce the multipole field 148 and act as the ICR antenna for the "twisted" or "untwisted" filers. In such an implementation, the wires 154 would carry a DC and an AC component to the current and thus establish both DC and AC components of the field 148. In some embodiments, the number of wires 154 used for a multipole may be high (more than the eight pairs shown), new phases could be introduced in the ICR drive to increase the coupling efficiency, or some arrangement like every other wire 154 could carry an ICR drive signal.

Referring again to FIG. 2A, system 10 uses a microwave horn 55 to direct the microwaves for the ECR plasma production. In some embodiments, a higher efficiency can be obtained using a cavity system (not shown). The cavity both localizes the microwaves and the gas used in the system 10. Localizing the microwaves is good in that it increases the microwave power density and thus the plasma density. Increasing the plasma density increase the number of ionizing collisions that can occur. It also reduces shielding and other problems from the microwaves.

Localizing the gas decreases the amount of wasted feed gas, generally not a large expense, but less waste is less waste and some rare feed gases are relatively expensive. This also reduces arcing problems caused by high gas pressures in the chamber 30. If the feed gas is localized in the cavity for the most part, it will not be in the antenna system, or the insulators. The lower the gas pressure can be kept outside the gas generator, the better for suppression of arcs.

It is not necessary for the cavity to be fully closed in a gas tight sense. A number of holes can be placed in the wall as long as they are small compared to the wavelength of the microwaves. This will confine the microwaves, but allow evacuation of the gas. Limiting the holes in the wall controls the conductance to the rest of the vacuum system. This can be used to keep the gas pressure high in the cavity but low in the rest of chamber 30.

The gas source 50 can be operated using a wide variety of material feeds. In most cases these feed systems provide a neutral stream of particles from which to make a plasma and thus a beam.

In the case of alpha production, helium gas is used as a working gas. In the case of most other gaseous materials they can be used as a working gas for the system. It does not matter if they are not simple atomic gasses. For example, if an oxygen ion source is desired, molecular oxygen can be injected into the source. The hot electrons will both dissociate the oxygen and ionize it.

For materials that are not normally a gas there are several ways to inject the material into the source. One alternative is to inject a gas containing the desired material. For example, carbon could be injected using CO or CO₂ as a working gas. In both cases, the plasma generated will contain both carbon and oxygen ions, thus the beam generated will contain both types of ions. The source may be followed by a mass filter to eliminate the undesired ions.

An alternative would be to vaporize the substance into system 10. In a case such as calcium, it would be possible to simply heat solid calcium to vaporize it using an oven. Materials could also be vaporized by e-beam. This type of source is well suited to production of materials with low melting points such as barium and calcium.

A laser system can be used to oblate a target, giving rise to neutral material from which the plasma is formed. Such a system would fire a laser at a cooled target located in the chamber to produce neutrals. The prime choice for the target location would be in the region 70 between the two magnetic mirror fields 32 and 34. In some embodiments, this location makes the optics some what difficult so placement to the rear of the system, near the peak of the rear mirror, has a number of advantages. Other placements are workable, but may require more laser power to generate sufficient neutral particles between the magnetic mirrors 32 and 34.

One way to inject material is to use sputtering. Here the exiting ECR source and magnetic mirrors may be used to generate a sputter source for almost any solid material. Referring to FIGS. 10A and 10B the ECR source may be adjusted to make unconfined hot electrons at resonant zones 210 and 211 on both sides of the rear mirror. The non-trapped hot electrons generated on the front and back of the mirrors are not useful for generating plasma 57. These electrons are not confined and typically are quickly lost. Further resonance zones 210 and 211 are typically very narrow so there is not sufficient time for the electrons to gain a lot of energy. However, in embodiments featuring a sputtering source, one can use the unconfined hot electrons on the back side of the mirror to form a sputter source. In such a case it would be desirable to tailor the magnetic field so the gradient is not so steep at zone 210 such that the resonance zone is sufficiently large to produce the desired plasma density.

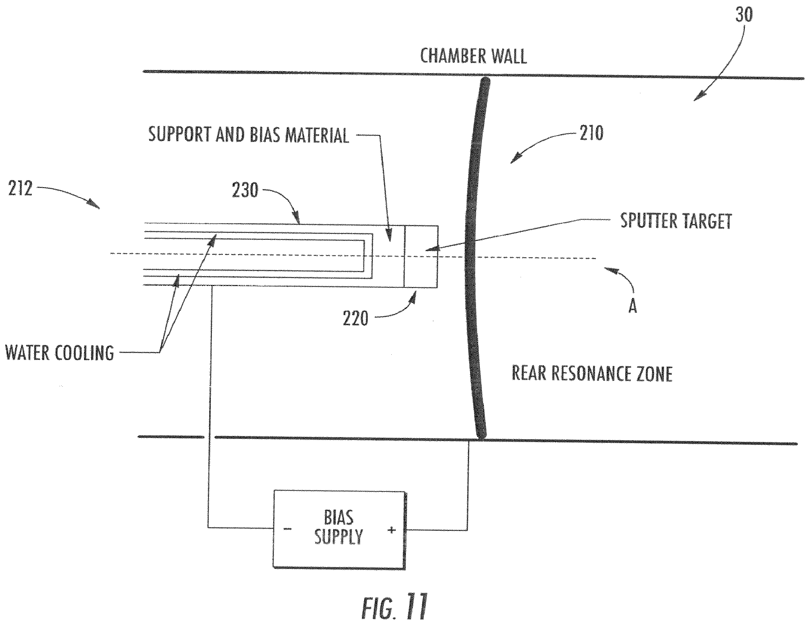

Referring to FIGS. 11, 12, and 13, a sputter source 212 works by allowing the hot electrons to ionize small amounts of gas to form a plasma in the vicinity of rear resonance zone 210. The sputter target is biased with a large negative bias (e.g. 1-4 kV). This negative bias draws ions from plasma formed and accelerates them to high energies. These ions then strike the sputter target 220 producing a number of neutral particles. These neutral particles then pass through the hot electrons in resonant zone 210. Some fraction of them are ionized, attracted by the negative potential, impact on the target 220, and sputter off more neutral particles. Some of the neutral particles pass through the hot electrons and become ionized in the trapped resonance zone 200 (in resonant mode) or zones 180 an 182 (in sub-resonant mode) and form part of the particle beam.

The target material 220 does not have to be electrically conducting in order to make a sputter target. For example, carbon can be used as a target by simply placing it on a conducting surface 230. The conductor 230 is biased to create the potential necessary to accelerate ions, but it is not necessary to bias the actual surface of target material 220. Conductor 230 my be isolated from the walls of chamber 30 by an insulator 240.

In some embodiments, sputter source 212 may include fluid cooling pipes. Any suitable cooling technique known in the art may be employed.

In some cases the target material 220 does not sputter well. This can be expressed as a sputter yield. The average number of neutral particles sputtered from the surface per single ion hitting the surface is the sputter yield. Materials that form good sputter targets have a yield greater then 1 (often significantly greater). If a material with a low sputter yield is desired, a carrier gas can be used to increase the yield. Generally heavy gasses such as xenon are desirable because they tend to have high sputter yields on most targets and cause minimal problems in the system. Some of the carrier gas will get ionized and find its way into the output beam, but this can be minimized by correct choice of the gas, geometrical arrangement, and/or filtered in the output beam.

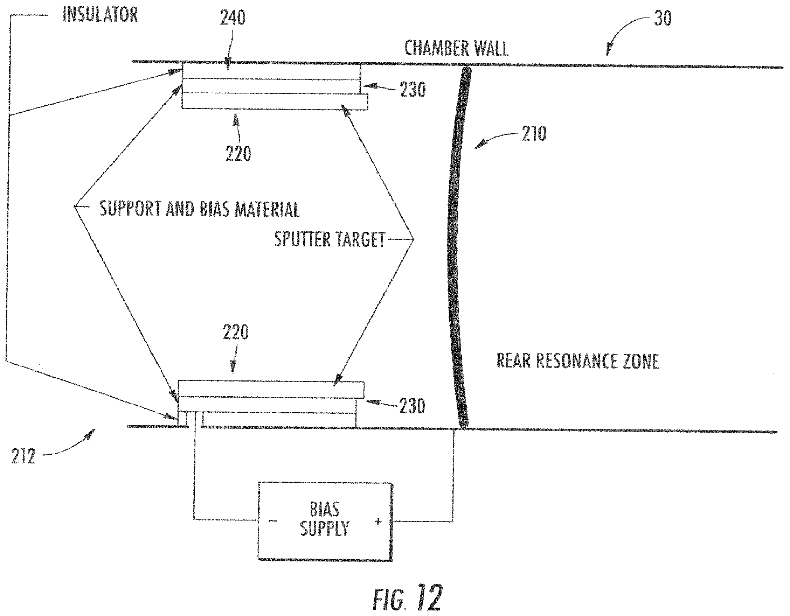

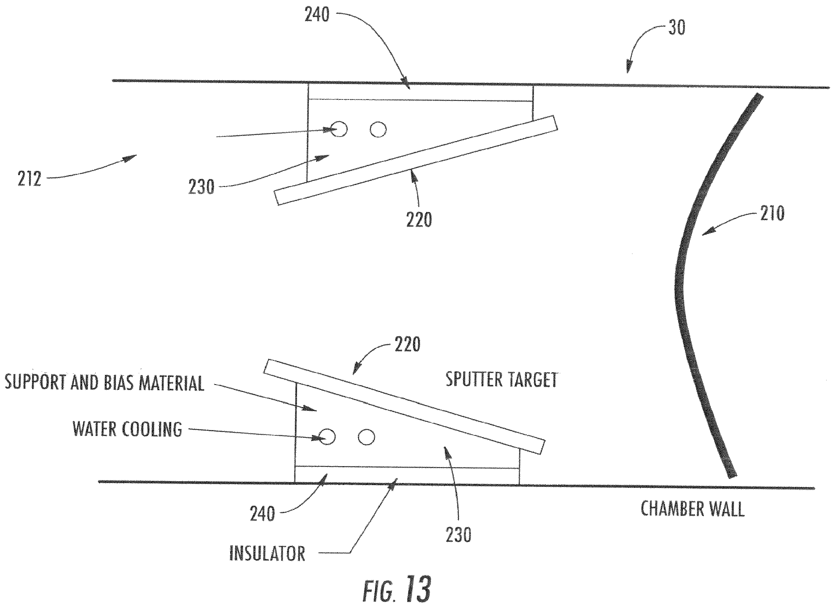

In some embodiments, the geometry of a sputter source 212 is important. It is necessary that ions from the plasma can be accelerated into the sputter target 220, that neutral particles have a clear path into the plasma 57, and that the source does not block key things such as the microwave access to the resonant zone. For example, sputter source 212 may fall into one of two geometrical configurations. These are a sputter target 212 located on axis A (as shown in FIG. 11) and one located in an annulus (as shown in FIG. 12) or cone (as shown in FIG. 13) around axis A.

An ECR sputter source may be particularly well suited for generation of multiply changed ion beams from solid materials. As a practical example, there are applications for highly charged nickel ion beams. This source is particularly well suited to production of a nickel ion beam.

Referring to FIG. 11, in the case of an axially located target 220, the sputter target covers a small area along the axis of the ion source. The ECR microwaves are allowed to flow around the target, and may even be injected off-axis to improve access.

In some embodiments, one may alternatively generate a sputter source using ions from the main confined plasma. Biasing is used to attract ions from the confined plasma to a sputtering target. For example, the ions may be drawn backwards into a plate on the axis biased negative relative to the plasma. In such embodiments, it is not necessary to create an unconfined plasma. In some embodiments, this may have advantages for microwave access at high plasma density.

The extraction system 59 passes the beam 56 through an extraction limiter 65, forming the first electrode of the extraction system. The beam 56 is allowed to follow the magnetic field and expand as the magnetic field decreases. A focusing lens 64 is used to converge the beam into the final limiter, which forms the boundary between the ion beam source system 10 and the following systems (e.g. a beam filter or accelerator).

By allowing the beam 56 to initially expand into a low field region then accelerating the beam to extraction energy, it is possible to transition the beam from the high field region magnetic field region 32, 34, and 40 to a low field region without increasing the beam emittance.

In various embodiments, other suitable extraction systems and techniques known in the art may be employed.

The vacuum system 54 can be implemented using almost any standard pumping system. The high vacuum pumps should provide a base pressure at least as low as 1×10⁻⁵ torr. During operation the gas or vapor from the atom source 50 can be bled into the system 10 at a higher pressure, providing high purity of the working gas.

There are a number of potential applications for high energy alpha (⁴He⁺⁺) or helium-3 (³He⁺⁺) beams. The most immediate applications are the activation of target nuclei for the production of radio-isotopes. Due to short half-life and/or low production yield, it is necessary to use an intense beam in order to produce reasonable quantities of many of these radio-isotopes. Also, by using a target of very high purity, few undesirable products are made so post processing (e.g. chemical separation) for isotope purity is minimized.

The following list indicates some of the possible target radio-isotopes that can be produced from various targets using He⁺⁺ beams:
¹⁸F, ¹²³Xe/I¹²³, ⁶⁷Ga, ¹¹¹In, ¹³¹Ba, ⁶⁸Ge, ⁸²Sr/Rb⁸², ⁸⁹Sr, ¹⁵³Sm, ¹²⁴I, ²¹¹At, ¹⁴⁸Gd, ⁷⁶Br, ¹⁹⁹Tl, ¹⁰⁰Pd, ¹²⁸Ba, ^{117m}Sn, and ²²⁹Th

Many of these radio-isotopes either are not currently produced or are only produced in very limited quantities because of the difficulties in their production. Using a ³He⁺⁺ or ⁴He⁺⁺ beam, however, many of these radio-isotopes can be effectively produced. For example alpha (⁴He⁺⁺) particles can be used to produce desirable products as follows:
¹²C (α, n) ¹⁵O
¹⁵N (α, n) ¹⁸F
⁷⁹Br (α, n) ⁸²Rb
⁸⁶Kr (α, n) ⁸⁹Sr
⁹⁶Zr (α, n) ⁹⁹Mo
¹⁰⁰Ru (α, n) ¹⁰³Pd
¹⁰⁶Pd (α, n) ¹⁰⁹Cd
¹¹⁴Cd (α, n) ^{117m}Sn
¹²¹Sb (α, n) ¹²⁴I
¹²⁰Te (α, n) ¹²³Xe(¹²³I)
⁶⁰Ni (α, 2n) ⁶²Zn(⁶²Cu)
⁶⁶Zn (α, 2n) ⁶⁸Ge(⁶⁸Ga)
⁸⁰Kr (α, 2n) ⁸²Sr(⁸²Rb)
⁸³Kr (α, 2n) ⁸⁵Sr
¹⁰⁹Ag (α, 2n) ¹¹¹In
¹²¹Sb (α, 2n) ¹²³I
¹²³Sb (α, 2n) ¹²⁵I
¹²⁹Xe (α, 2n) ¹³¹Ba(¹³¹Cs)
¹⁹⁷Au (α, 2n) ¹⁹⁹Tl + 2n
¹⁹⁹Hg (α, 2n) ²⁰¹Pb(²⁰¹Tl)
²⁰⁶Pb (α, 2n) ²⁰⁸Po
²⁰⁹Bi (α, 2n) ²¹¹At
⁶¹Ni (α, p) ⁶⁴Cu
⁶⁴Ni (α, p) ⁶⁷Cu
¹⁰⁸Cd (α, p) ¹¹¹In
¹¹⁴Cd (α, p) ¹¹⁷In(¹¹⁷Sn)
¹²⁰Te (α, p) ¹²³I
¹²²Te (α, p) ¹²⁵I
¹⁶³Dy (α, p) ¹⁶⁶Ho
¹⁷⁴Yb (α, p) ¹⁷⁷Lu

Other transmutations can occur to produce the same product, for example:
¹⁴⁴Sm (α, gamma) ¹⁴⁸Gd
¹⁴⁷Sm (α, 3n) ¹⁴³Gd
¹⁴⁷Sm (³He⁺⁺, 2n) ¹⁴⁸Gd

For some reactions, production using alpha particles is greatly improved relative to other methods. Examples include
¹⁰⁸Cd (α, p) ¹¹¹In
¹²¹Sb (α, 2n) ¹²³I
⁸³Kr (α, 2n) ⁸⁵Sr
¹⁵N (α, n) ¹⁸F
⁶⁶Zn (α, 2n) ⁶⁸Ge(⁶⁸Ga)
¹⁵⁰Nd (α, n) ¹⁵³Sm
⁹⁶Zr (α, n) ⁹⁹Mo
¹²¹Sb (α, n) ¹²⁴I
¹⁹⁷Au (α, 2n) ¹⁹⁹Tl

Some isotopes that can be produced, e.g. in usable quantities, essentially exclusively with alpha (or He-3) particles. Exemplary reactions include
²⁰⁹Bi (α, 2n) ²¹¹At
¹²¹Sb (α, n) ¹²⁴I
¹⁴⁴Sm (α, gamma) ¹⁴⁸Gd
¹⁴⁷Sm (α, 3n) ¹⁴⁸Gd
¹⁴⁷Sm (³He, 2n) ¹⁴⁸Gd
¹¹⁶Cd(α,3n)^{117m}Sn

In some embodiments, a beam of deuterium ions may be used to drive the following reactions:
³⁰Te (d,n) ¹³¹I +
²⁰⁰Hg (d, n) ²⁰¹Tl
¹³⁰Te (d, n) ¹³¹I
⁶⁴Ni (d, 2n) ⁶⁴Cu
¹⁵N (d, 2n) ¹⁵O
¹³²Xe (d, 2n) ¹³²Cs
¹¹⁰Cd (d, n) ¹¹¹In
¹⁷⁶Yb (d, n) ¹⁷⁷Lu

In some embodiments, a beam of protons (Hydrogen ions) may be used to drive the following reactions:
¹⁸O (p, n) ¹⁸F
¹²⁴Te(p, n) ¹²⁴I
¹²⁴Te (p, 2n) ¹²³I
⁸⁵Rb (p, 4n) ⁸²Sr
²⁰¹Hg (p,n) ²⁰¹Tl

Ion sources of the types described herein may also drive reactions such as:
⁶⁷Zn (³He, 2n) ⁶⁸Ga
¹⁹⁹Hg (³He, n) ²⁰¹Tl
¹⁶O (³He, p) ¹⁸F
⁶¹Ni (α, p) ⁶⁴Cu
⁶⁴Ni (α, p) ⁶⁷Cu
¹⁰⁸Cd (α, p ) ¹¹¹In
¹¹⁴Cd (α, p) ^{117m}In(^{117m}Sn)
¹²⁰Te (α, p) ¹²³I
¹²²Te (α, p) ¹²⁵I
¹⁶³Dy (α, p) ¹⁶⁶Ho
¹⁷⁴Yb (α, p) ¹⁷⁷Lu

As noted above, for treatment of radioactive waste, there are at least two types of radioactive waste transmutation. The first is the production of useful products from waste material. Exemplary transmutations which may be accomplished using the devices and techniques described herein include:
²²⁶Ra (α, n) ²³⁰Th + n. (²³⁰Th is a source for ²¹³Bi.)
²³²Th + α, → ²³⁵U which is nuclear fuel.
²³⁵U + α → ²³⁸Pu which is used in nuclear fuel cells as a heat source and is in short supply.
²³¹Pa + α + ²³³Np + n--> ²²⁹Pa--> ²²⁵Ac which is a medical isotope. The ²²⁵Ac decay path is ²²⁵Ac -α-> ²²¹Fr -α-> ²¹⁷At -α-> ²¹³Bi -beta-> ²¹³Po -α-> ²⁰⁹Pb -beta-> ²⁰⁹Bi.

Second, waste may be converted to a stable product. Exemplary transmutations which may be accomplished using the devices and techniques described herein include:
²⁵¹Cf + α → ²⁵³Fm + 2n converts long lived Cf isotopes to short lived (approximately 3 days) Fm isotope, ²³⁷Np + α → ²³⁹Am + n → ²³⁵Np → ²³¹Pa + ... → Pb.

Another other issue in treatment of nuclear waste is stimulated fission reactions. In this case heavy radioactive nuclides are bombarded with alpha particles from a beam source of the type described herein. These nuclides undergo a stimulated fission reaction and fall apart into a number of lighter fragments. Generally the fragments are still radioactive, but have short half-lives and quickly decay to stable elements. Unlike many of the heavy nuclei, which are alpha and neutron emitters, these lighter ones are more likely beta and position emitters, which are easier to deal with. Intense (very intense) alpha beams are ideal for this type of application.

^{99m}Tc is a metastable nuclear isomer of ⁹⁹Tc, indicated by the "m". "Metastable" means that ^{99m}Tc does not change into another element upon its decay. Instead ^{99m}Tc emits a 140 keV gamma ray that medical equipment can detect from a body into which it has been injected. Accordingly ^{99m}Tc is well suited for the role of a medical tracer because it emits readily detectable 140 keV gamma rays, and its half-life for gamma emission is 6.01 hours. Over 93% of it decays to ⁹⁹Tc in 24 hours. This short half life of the ^{99m}Tc allows for scanning procedures which collect data rapidly, but keep total patient radiation exposure low. ⁹⁹Tc is the ground state of ^{99m}Tc that eventually (half-life of 213 thousand years) emits a beta particle and decays to ⁹⁹Ru, which is stable.

^{99m}Tc usually is extracted from so called "moo cows", ^{99m}Tc generators which contain ⁹⁹Mo. The majority of ⁹⁹Mo heretofore produced for ^{99m}Tc medical use comes from fission in nuclear reactors, and must be processed carefully to remove nuclear contaminates.

20 million diagnostic nuclear medical procedures every year use ^{99m}Tc, approximately 85% of diagnostic imaging procedures in nuclear medicine use this isotope. Depending on the type of nuclear medicine procedure, the ^{99m}Tc is bound to different pharmaceutical that transports it to the required location. ^{99m}Tc is chemically bound to Sestamibi when it is used to image the blood flow, or lack thereof, in the heart. Since Exametazime, is able to cross the blood brain barrier, ^{99m}Tc is used with Exametazime so the ^{99m}Tc flows through the vessels in the brain to image cerebral blood flow. Imaging of renal function is accomplished by tagging ^{99m}Tc to Mercapto Acetyl Tri Glycine.

Similarly, ¹¹¹In is a radionuclide with a half-life of 2.8049 days and with gamma ray emissions of 171.2 and 245.3 keV. In a chloride form, it is used as a bone marrow and tumor-localizing tracer; in a chelate form, as a cerebrospinal fluid tracer and in a trichloride form, is used in electron microscopy to stain nucleic acids in thin tissue sections. It decays by electron capture:
¹¹¹In → ¹¹¹Cd + γ(171.2 keV) + γ(245.3 keV)
Electron capture decay can be though of as a positron decay where the positron is destroyed in the nucleus by an captured electron. In this case the decay produces the gamma ray emissions of 171.2 and 245.3 keV sensed in the PET scan.

For many applications, due to short half-life and/or low production yield, it is necessary to use an intense alpha particle beam in order to produce reasonable quantities of ⁹⁹Mo or ¹¹¹In. Particles beams of the type described herein may be used to produce diagnostic or therapeutically effective doses of these materials. As used herein, the phrase diagnostic or therapeutically effective dose is to be understood to mean a dose sufficient to perform at least one diagnostic or therapeutic procedure is a human or animal patient.

Advantageously, the devices and techniques described herein may be used to produce usable quantities of ⁹⁹Mo or ¹¹¹In without the use a nuclear fission reactor. Accordingly, production of dangerous radioactive byproducts may be reduced or eliminated. Also, by using beam targets of very high purity, few undesirable products are made so post processing for isotope purity is improved.

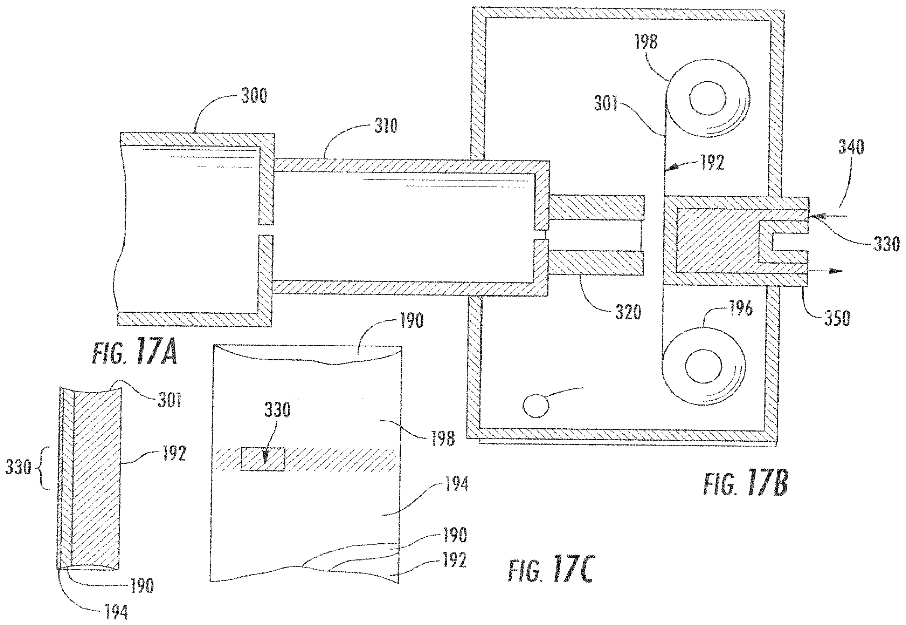

Referring to FIGS. 17A, 17B, and 17C one exemplary production process is to form a target 301 by placing a layer 190 of ⁹⁶Zr atoms on a copper strip 192 and then place a thin layer 194 of ¹⁰⁹Ag atoms on the layer 190 of ⁹⁶Zr atoms. The strip 192 is shown extending between a supply roll 196 and a take-up roll 198.

A beam from ion source 300 is accelerated by accelerator 310 to target 301. In some embodiments, accelerators 310 functions in a pulse mode so after the beam is spread into a rectangular shape by the beam spreader 320, either a pulse or more of alpha particles is directed at a rectangular area 330 of the strip 192 (in other embodiments, other beam shapes may be used). The target strip 301 is then indexed or moved continuously with respect to the beam. A cooling system can be used to cool the target 301. For example coolant may be circulated via ports 350. Any suitable cooling technique known in the art may be used.

In some embodiments, alpha particles are accelerated to the target 301 at an energy of approximately 28 MeV to transmute a portion of the ¹⁰⁹Ag atoms of layer 194 into ¹¹¹In. Alpha particles passing through layer 194 will lose some energy in the process, and thereafter, a portion will impinge on layer 190 at an energy of approximately 16 MeV, transmuting a portion of the ⁹⁶Zr atoms or layer 190 into ⁹⁹Mo. The copper, ¹⁰⁹Ag, ¹¹¹In, ⁹⁶Zr, and ⁹⁹Mo are easy to separate chemically so the copper, ¹⁰⁹Ag and ⁹⁶Zr remaining are recycled, and the ⁹⁹Mo and ¹¹¹In are chemically separated and used for medical isotope purposes.

Similar techniques may be used for targets with more that two layers of different target materials, or with a single layer of target material.

Although embodiments are shown above with target 301 mounted on a roll, and other suitable target mount may be used. In some embodiments, target 301 may mounted on a plate (not shown). The target plate is placed in front of the beam to undergo reactions, after which the plate may be changed. In some embodiments, a target station would support more then one plate at a time. This allows a first plate to be exposed to the beam while another plate is changed out and a new plate made ready during the exposure of the first plate. This reduces beam down time. Further, using plates in this manner allows the exposed product, which may have a short half-life, to be taken out quickly.

## Claims

1. An ion source comprising:
a chamber (30) disposed about a longitudinal axis and containing a gas;
a magnetic confinement system configured to produce a magnetic field in a confinement region within the chamber, wherein the confinement region is disposed about the longitudinal axis and extends along the longitudinal axis from a proximal end to a distal end, the magnetic confinement system comprising a first magnetic mirror coil (36) positioned adjacent to the chamber at a proximal end of the confinement region, a second magnetic mirror coil (38) positioned adjacent the chamber at a distal end of the confinement region, and a magnet (42) which includes a multipole-magnet, positioned adjacent to the chamber along the confinement region between the proximal end and the distal end, wherein:
a substantially uniform magnetic field (40) is disposed about and directed substantially parallel to the longitudinal axis between the first magnetic mirror coil (36) and the second magnetic mirror coil (38), wherein magnet (42) which includes the multipole-magnet is configured to produce the substantially uniform magnetic field (40) and confines radial motion of the plasma away from the longitudinal axis;
the first magnetic mirror coil (36) is configured to produce a first magnetic mirror (32) located at the proximal end of the confinement region that is directed substantially along the longitudinal axis, and has a magnitude which increases as a function of axial distance from the substantially uniform magnetic field to a peak magnitude greater than the magnitude of the substantially uniform radial magnetic field; and
the second magnetic mirror coil (38) is configured to produce a second magnetic mirror (34) located at the distal end of the confinement region that is directed substantially along the longitudinal axis, and has a magnitude that increases as a function of axial distance from the substantially uniform radial magnetic field to a peak magnitude greater than the magnitude of the substantially radial uniform magnetic field,
wherein the first and second magnetic mirror coils (36, 38) are configured such that the peak magnitude of the first magnetic mirror is greater than the peak magnitude of the second magnetic mirror;
an electron cyclotron resonance driver (44) configured to produce a time varying electric field having a frequency substantially de-tuned to the electron cyclotron resonance frequency corresponding to the substantially uniform magnetic field which drives the cyclotron motion of electrons located within the confinement region to interact with the gas to form a plasma that is confined by the substantially uniform radial magnetic field between the first magnetic mirror and the second magnetic mirror; and
an ion cyclotron resonance exciter (62) comprising an antenna (68, 90) disposed within the chamber between the first and second magnetic mirror coils (36, 38), the ion cyclotron resonance exciter comprising a radio frequency drive system (96) and a tuning system (100) configured to direct radiation to the confinement region at a frequency selected to preferentially drive the cyclotron motion of ions in the plasma having a selected ionization state to increase the velocity of said ions in directions perpendicular to the longitudinal axis without coupling to ions of a desired output ionization state,
wherein, during operation, the first magnetic mirror coil, second magnetic mirror coil and magnet (42) which includes the multi-pole magnet of the magnetic confinement system are operated to produce a magnetic field that confines the plasma in the confinement region, and the electron cyclotron resonance driver and the ion cyclotron resonance exciter are operated such that a portion of atoms in the plasma experience multiple ionizing interactions with the driven electrons to form multiply ionized ions having the desired output ionization state.

2. The ion source of claim 1, wherein the magnet (42) which includes the multi-pole magnet of the magnetic confinement system is configured to produce the substantially uniform magnetic field with a magnitude that is a local axial minimum of the magnetic field in the confinement region.

3. The ion source of claim 1, further comprising an extractor (59) within the chamber at the distal end, the extractor comprising a series of electrodes and focusing elements configured to extract a beam of ions from the confinement region.

4. The ion source of claim 1, wherein the electron cyclotron resonance driver is configured to produce a time varying electric field having a frequency substantially tuned to the electron cyclotron resonance frequency corresponding to the substantially uniform magnetic field so as to drive the cyclotron motion of electrons located throughout a volume containing the substantially uniform magnetic field.

5. The ion source of claim 1, wherein the magnet (42) which includes the multi-pole magnet of the magnetic confinement system are configured to produce the magnetic field so that the magnitude of the substantially uniform magnetic field varies by less than 10% over a region disposed about the longitudinal axis, said region located midway between the first and second magnetic mirror coils and extending along the longitudinal axis over a distance equal to at least about 25% of the axial distance between the first and second magnetic mirror coils.

6. The ion source of claim 1, wherein the magnetic confinement system is configured to produce the magnetic field so that the magnetic field is azimuthally symmetric about the longitudinal axis throughout the confinement region.

7. The ion source of claim 1, wherein the ion cyclotron resonance exciter (62) is configured to direct radiation to the confinement region having a frequency substantially tuned to the ion cyclotron frequency of ions having the selected driven ionization state in the substantially uniform magnetic field.

8. The ion source of claim 1, wherein the ion cyclotron resonance exciter (62) is configured to direct radiation to the confinement region at a plurality of frequencies in which each frequency is substantially tuned to the ion cyclotron frequency in the substantially uniform magnetic field of ions having a respective selected ionization state other than the desired output ionization state.

9. The ion source of claim 7, wherein the ion cyclotron resonance exciter antenna is chosen from the group consisting of: a twisted bi-filar antenna, a twisted filar antenna, an untwisted bi-filar antenna or an untwisted filar antenna.

10. The ion source of claim 1, wherein:
the first magnetic mirror coil is configured to produce the first magnetic mirror such that a portion of the magnetic field extends outside of the confinement region;
the electron cyclotron resonance driver is tuned to the electron cyclotron frequency corresponding to the portion of the magnetic field extending outside of the confinement region to drive cyclotron motion of unconfined electrons in said portion of the field, wherein said unconfined electrons interact with the gas in the chamber to form an unconfined plasma; and
the ion source further comprises a sputter target (220) located in the chamber proximal to said portion of the magnetic field, wherein the ion source is biased to attract ions from the unconfined plasma, and the sputter source is configured to emit neutral particles in response to collisions with the attracted ions to form at least a portion of the gas in the chamber.

11. The ion source of claim 10, wherein the sputter target comprises at least one selected from the list consisting of: an annulus of material disposed about the longitudinal axis, an annulus of material disposed about the longitudinal axis and having a target surface which is angled with respect to the longitudinal axis, or a target material positioned about and extending along the longitudinal axis.

12. The ion source of claim 11, further comprising an extractor configured to extract a beam of He ions from the confinement region, wherein the beam comprises ⁴He⁺⁺ or ³He⁺⁺ ions.

13. The ion source of claim 1, wherein the magnet (42) which includes the multi-pole magnet of the magnetic confinement system is configured to produce a magnetic field directed azimuthally to the longitudinal axis having a magnitude that decreases radially with increasing proximity to the axis, except along one or more cusps.

14. The ion source of claim 1, wherein the electron cyclotron resonance driver is configured to produce a time varying electric field having a frequency that drives the cyclotron motion of electrons located in a first region (180) of the first magnetic field generated by the first magnetic mirror coil and in a second region (182) of the second magnetic field but is substantially de-tuned to the electron cyclotron resonance frequency corresponding to the substantially uniform magnetic field of the confinement region.

## Patentansprüche

1. Ionenquelle, umfassend:
eine Kammer (30), die um eine Längsachse angeordnet ist und ein Gas enthält;
ein Magneteinschlusssystem, das dazu konfiguriert ist, ein Magnetfeld in einer Einschlussregion innerhalb der Kammer zu produzieren, wobei die Einschlussregion um die Längsachse angeordnet ist und sich entlang der Längsachse von einem proximalen Ende zu einem distalen Ende erstreckt, wobei das Magneteinschlusssystem eine erste Magnetspiegelspule (36), die benachbart zu der Kammer an einem proximalen Ende der Einschlussregion positioniert ist, eine zweite Magnetspiegelspule (38), die benachbart zu der Kammer an einem distalen Ende der Einschlussregion positioniert ist, und einen Magneten (42) umfasst, der einen Multipolmagneten beinhaltet, der benachbart zu der Kammer entlang der Einschlussregion zwischen dem proximalen Ende und dem distalen Ende positioniert ist, wobei:
ein im Wesentlichen einheitliches Magnetfeld (40) um die Längsachse zwischen der ersten Magnetspiegelspule (36) und der zweiten Magnetspiegelspule (38) angeordnet und im Wesentlichen parallel dazu gerichtet ist, wobei der Magnet (42), der den Multipolmagneten beinhaltet, dazu konfiguriert ist, das im Wesentlichen einheitliche Magnetfeld (40) zu produzieren und radiale Bewegung des Plasmas weg von der Längsachse einschließt;
die erste Magnetspiegelspule (36) dazu konfiguriert ist, einen ersten Magnetspiegel (32) zu produzieren, der sich an dem proximalen Ende der Einschlussregion befindet, der im Wesentlichen entlang der Längsachse gerichtet ist und eine Größe aufweist, die sich als eine Funktion von axialem Abstand von dem im Wesentlichen einheitlichen Magnetfeld auf eine Spitzengröße erhöht, die größer als die Größe des im Wesentlichen einheitlichen radialen Magnetfeldes ist; und
die zweite Magnetspiegelspule (38) dazu konfiguriert ist, einen zweiten Magnetspiegel (34) zu produzieren, der sich an dem distalen Ende der Einschlussregion befindet, der im Wesentlichen entlang der Längsachse gerichtet ist und eine Größe aufweist, die sich als eine Funktion von axialem Abstand von dem im Wesentlichen einheitlichen radialen Magnetfeld auf eine Spitzengröße erhöht, die größer als die Größe des im Wesentlichen radialen einheitlichen Magnetfeldes ist,
wobei die erste und die zweite Magnetspiegelspule (36, 38) konfiguriert sind, sodass die Spitzengröße des ersten Magnetspiegels größer als die Spitzengröße des zweiten Magnetspiegels ist;
einen Elektronenzyklotronresonanztreiber (44), der dazu konfiguriert ist, ein zeitvariierendes elektrisches Feld mit einer Frequenz zu produzieren, die im Wesentlichen auf die Elektronenzyklotronresonanzfrequenz entsprechend dem im Wesentlichen einheitlichen Magnetfeld verstimmt ist, der die Zyklotronbewegung von Elektronen antreibt, die sich innerhalb der Einschlussregion befinden, um mit dem Gas zu interagieren, um ein Plasma zu bilden, das durch das im Wesentlichen einheitliche radiale Magnetfeld zwischen dem ersten Magnetspiegel und dem zweiten Magnetspiegel eingeschlossen ist; und
einen Ionenzyklotronresonanzerreger (62), der eine Antenne (68, 90) umfasst, die innerhalb der Kammer zwischen der ersten und der zweiten Magnetspiegelspule (36, 38) angeordnet ist, wobei der Ionenzyklotronresonanzerreger ein Hochfrequenzantriebssystem (96) und ein Abstimmsystem (100) umfasst, das dazu konfiguriert ist, Strahlung auf die Einschlussregion mit einer Frequenz zu richten, die dazu ausgewählt ist, die Zyklotronbewegung von Ionen in dem Plasma mit einem ausgewählten Ionisierungszustand bevorzugt anzutreiben, um die Geschwindigkeit der Ionen in Richtungen senkrecht zu der Längsachse zu erhöhen, ohne an Ionen eines gewünschten Ausgangsionisierungszustands zu koppeln,
wobei während Betrieb die erste Magnetspiegelspule, die zweite Magnetspiegelspule und der Magnet (42), der den Multipolmagneten des Magneteinschlusssystems beinhaltet, betrieben werden, um ein Magnetfeld zu produzieren, welches das Plasma in der Einschlussregion einschließt, und der Elektronenzyklotronresonanztreiber und der Ionenzyklotronresonanzerreger betrieben werden, sodass ein Teil von Atomen in dem Plasma mehrere ionisierende Wechselwirkungen mit den angetriebenen Elektronen erfährt, um mehrfach ionisierte Ionen mit dem gewünschten Ausgangsionisierungszustand zu bilden.

2. Ionenquelle nach Anspruch 1, wobei der Magnet (42), der den Multipolmagneten des Magneteinschlusssystems beinhaltet, dazu konfiguriert ist, das im Wesentlichen einheitliche Magnetfeld mit einer Größe zu produzieren, die ein lokales axiales Minimum des Magnetfeldes in der Einschlussregion ist.

3. Ionenquelle nach Anspruch 1, ferner umfassend einen Extraktor (59) innerhalb der Kammer an dem distalen Ende, wobei der Extraktor eine Reihe von Elektroden und Fokussierelementen umfasst, die dazu konfiguriert sind, einen Ionenstrahl aus der Einschlussregion zu extrahieren.

4. Ionenquelle nach Anspruch 1, wobei der Elektronenzyklotronresonanztreiber dazu konfiguriert ist, ein zeitvariierendes elektrisches Feld mit einer Frequenz zu produzieren, die im Wesentlichen auf die Elektronenzyklotronresonanzfrequenz entsprechend dem im Wesentlichen einheitlichen Magnetfeld abgestimmt ist, um die Zyklotronbewegung von Elektronen anzutreiben, die sich durch ein Volumen befinden, welches das im Wesentlichen einheitliche Magnetfeld enthält.

5. Ionenquelle nach Anspruch 1, wobei der Magnet (42), der den Multipolmagneten des Magneteinschlusssystems beinhaltet, dazu konfiguriert ist, das Magnetfeld zu produzieren, sodass die Größe des im Wesentlichen einheitlichen Magnetfeldes um weniger als 10 % über eine Region variiert, die um die Längsachse angeordnet ist, wobei sich die Region in der Mitte zwischen der ersten und der zweiten Magnetspiegelspule befindet und sich entlang der Längsachse über einen Abstand erstreckt, der zumindest gleich etwa 25 % des axialen Abstands zwischen der ersten und der zweiten Magnetspiegelspule ist.

6. Ionenquelle nach Anspruch 1, wobei das Magneteinschlusssystem dazu konfiguriert ist, das Magnetfeld zu produzieren, sodass das Magnetfeld azimutal symmetrisch um die Längsachse durch die Einschlussregion ist.

7. Ionenquelle nach Anspruch 1, wobei der Ionenzyklotronresonanzerreger (62) dazu konfiguriert ist, Strahlung auf die Einschlussregion mit einer Frequenz zu richten, die im Wesentlichen auf die Ionenzyklotronfrequenz von Ionen mit dem ausgewählten angetriebenen Ionisierungszustand in dem im Wesentlichen einheitlichen Magnetfeld abgestimmt ist.

8. Ionenquelle nach Anspruch 1, wobei der Ionenzyklotronresonanzerreger (62) dazu konfiguriert ist, Strahlung auf die Einschlussregion bei einer Vielzahl von Frequenzen zu richten, bei denen jede Frequenz im Wesentlichen auf die Ionenzyklotronfrequenz in dem im Wesentlichen einheitlichen Magnetfeld von Ionen mit einem jeweiligen ausgewählten anderen Ionisierungszustand als dem gewünschten Ausgangsionisierungszustand abgestimmt ist.

9. Ionenquelle nach Anspruch 7, wobei die Ionenzyklotronresonanzerregerantenne gewählt ist aus der Gruppe bestehend aus: einer verdrillten Bifilarantenne, einer verdrillten Filarantenne, einer unverdrillten Bifilarantenne oder einer unverdrillten Filarantenne.

10. Ionenquelle nach Anspruch 1, wobei:
die erste Magnetspiegelspule dazu konfiguriert ist, den ersten Magnetspiegel zu produzieren, sodass sich ein Teil des Magnetfeldes außerhalb der Einschlussregion erstreckt;
der Elektronenzyklotronresonanztreiber auf die Elektronenzyklotronfrequenz entsprechend dem Teil des Magnetfeldes abgestimmt ist, der sich außerhalb der Einschlussregion erstreckt, um Zyklotronbewegung von uneingeschlossenen Elektronen in dem Teil des Feldes anzutreiben, wobei die uneingeschlossenen Elektronen mit dem Gas in der Kammer interagieren, um ein uneingeschlossenes Plasma zu bilden; und
die Ionenquelle ferner ein Sputterziel (220) umfasst, das sich in der Kammer proximal zu dem Teil des Magnetfeldes befindet, wobei die Ionenquelle vorgespannt ist, um Ionen aus dem uneingeschlossenen Plasma anzuziehen, und die Sputterquelle dazu konfiguriert ist, neutrale Partikel als Reaktion auf Kollisionen mit den angezogenen Ionen zu emittieren, um zumindest einen Teil des Gases in der Kammer zu bilden.

11. Ionenquelle nach Anspruch 10, wobei das Sputterziel zumindest eines ausgewählt aus der Liste bestehend aus Folgendem umfasst: einem Materialring, der um die Längsachse angeordnet ist, einem Materialring, der um die Längsachse angeordnet ist und eine Zieloberfläche aufweist, die in Bezug auf die Längsachse gewinkelt ist, oder einem Zielmaterial, das um die Längsachse angeordnet ist und sich entlang dieser erstreckt.

12. Ionenquelle nach Anspruch 11, ferner umfassend einen Extraktor, der dazu konfiguriert ist, einen Strahl von He-Ionen aus der Einschlussregion zu extrahieren, wobei der Strahl ⁴He⁺⁺- oder ³He⁺⁺-Ionen umfasst.

13. Ionenquelle nach Anspruch 1, wobei der Magnet (42), der den Multipolmagneten des Magneteinschlusssystems beinhaltet, dazu konfiguriert ist, ein Magnetfeld, das azimutal zu der Längsachse gerichtet ist, mit einer Größe zu produzieren, die mit sich erhöhender Nähe zu der Achse radial abnimmt, außer entlang einem oder mehreren Scheitelpunkten.

14. Ionenquelle nach Anspruch 1, wobei der Elektronenzyklotronresonanztreiber dazu konfiguriert ist, ein zeitvariierendes elektrisches Feld mit einer Frequenz zu produzieren, das die Zyklotronbewegung von Elektronen antreibt, die sich in einer ersten Region (180) des ersten Magnetfeldes, das durch die erste Magnetspiegelspule erzeugt wird, und in einer zweiten Region (182) des zweiten Magnetfeldes befinden, aber im Wesentlichen auf die Elektronenzyklotronresonanzfrequenz entsprechend dem im Wesentlichen einheitlichen Magnetfeld der Einschlussregion verstimmt ist.

## Revendications

1. Source d'ions comprenant :
une chambre (30) disposée autour d'un axe longitudinal et contenant un gaz ;
un système de confinement magnétique configuré pour produire un champ magnétique dans une région de confinement à l'intérieur de la chambre, dans laquelle la région de confinement est disposée autour de l'axe longitudinal et s'étend le long de l'axe longitudinal d'une extrémité proximale à une extrémité distale, le système de confinement magnétique comprenant une première bobine de miroir magnétique (36) positionnée de manière adjacente à la chambre à une extrémité proximale de la région de confinement, une seconde bobine de miroir magnétique (38) positionnée de manière adjacente à la chambre à une extrémité distale de la région de confinement, et un aimant (42), qui comprend un aimant multipolaire, positionné de manière adjacente à la chambre le long de la région de confinement entre l'extrémité proximale et l'extrémité distale, dans laquelle :
un champ magnétique sensiblement uniforme (40) est disposé autour de l'axe longitudinal et dirigé sensiblement parallèlement à celui-ci entre la première bobine de miroir magnétique (36) et la seconde bobine de miroir magnétique (38), dans laquelle l'aimant (42), qui comprend l'aimant multipolaire, est configuré pour produire le champ magnétique sensiblement uniforme (40) et pour confiner un mouvement radial du plasma à distance de l'axe longitudinal ;
la première bobine de miroir magnétique (36) est configurée pour produire un premier miroir magnétique (32) situé à l'extrémité proximale de la région de confinement, qui est dirigé sensiblement le long de l'axe longitudinal et dont l'amplitude augmente en fonction d'une distance axiale par rapport au champ magnétique sensiblement uniforme jusqu'à une amplitude de crête supérieure à l'amplitude du champ magnétique radial sensiblement uniforme ; et
la seconde bobine de miroir magnétique (38) est configurée pour produire un second miroir magnétique (34) situé à l'extrémité distale de la région de confinement, qui est dirigé sensiblement le long de l'axe longitudinal et dont l'amplitude augmente en fonction d'une distance axiale par rapport au champ magnétique radial sensiblement uniforme jusqu'à une amplitude de crête supérieure à l'amplitude du champ magnétique radial sensiblement uniforme,
dans laquelle les première et seconde bobines de miroir magnétique (36, 38) sont configurées de sorte que l'amplitude de crête du premier miroir magnétique soit supérieure à l'amplitude de crête du second miroir magnétique ;
un dispositif d'entraînement de résonance cyclotronique électronique (44) configuré pour produire un champ électrique variable dans le temps ayant une fréquence sensiblement désaccordée par rapport à la fréquence de résonance cyclotronique électronique correspondant au champ magnétique sensiblement uniforme, qui entraîne le mouvement cyclotronique d'électrons situés dans la région de confinement afin qu'ils interagissent avec le gaz pour former un plasma qui est confiné par le champ magnétique radial sensiblement uniforme entre le premier miroir magnétique et le second miroir magnétique ; et
un excitateur de résonance cyclotronique ionique (62) comprenant une antenne (68, 90) disposée à l'intérieur de la chambre entre les première et seconde bobines de miroir magnétique (36, 38), l'excitateur de résonance cyclotronique ionique comprenant un système d'entraînement par radiofréquence (96) et un système d'accord (100) configurés pour diriger un rayonnement vers la région de confinement à une fréquence sélectionnée pour entraîner préférentiellement le mouvement cyclotronique d'ions du plasma présentant un état d'ionisation sélectionné, afin d'augmenter la vitesse desdits ions dans des directions perpendiculaires à l'axe longitudinal sans couplage avec des ions d'un état d'ionisation de sortie souhaité,
dans laquelle, en fonctionnement, la première bobine de miroir magnétique, la seconde bobine de miroir magnétique et l'aimant (42), qui comprend l'aimant multipolaire du système de confinement magnétique, sont actionnés pour produire un champ magnétique qui confine le plasma dans la région de confinement, et le dispositif d'entraînement de résonance cyclotronique électronique et l'excitateur de résonance cyclotronique ionique sont actionnés de sorte qu'une partie d'atomes du plasma subissent de multiples interactions ionisantes avec les électrons entraînés pour former des ions multiplement ionisés présentant l'état d'ionisation de sortie souhaité.

2. Source d'ions de la revendication 1, dans laquelle l'aimant (42), qui comprend l'aimant multipolaire du système de confinement magnétique, est configuré pour produire le champ magnétique sensiblement uniforme avec une amplitude qui est un minimum axial local du champ magnétique dans la région de confinement.

3. Source d'ions de la revendication 1, comprenant en outre un extracteur (59) à l'intérieur de la chambre, à l'extrémité distale, l'extracteur comprenant une série d'électrodes et d'éléments de focalisation configurés pour extraire un faisceau d'ions de la région de confinement.

4. Source d'ions de la revendication 1, dans laquelle le dispositif d'entraînement de résonance cyclotronique électronique est configuré pour produire un champ électrique variable dans le temps ayant une fréquence sensiblement accordée sur la fréquence de résonance cyclotronique électronique correspondant au champ magnétique sensiblement uniforme, de manière à entraîner le mouvement cyclotronique d'électrons situés dans l'ensemble d'un volume contenant le champ magnétique sensiblement uniforme.

5. Source d'ions de la revendication 1, dans laquelle l'aimant (42), qui comprend l'aimant multipolaire du système de confinement magnétique, est configuré pour produire le champ magnétique de sorte que l'amplitude du champ magnétique sensiblement uniforme varie de moins de 10 % sur une région disposée autour de l'axe longitudinal, ladite région étant située à mi-distance entre les première et seconde bobines de miroir magnétique et s'étendant le long de l'axe longitudinal sur une distance égale à au moins environ 25 % de la distance axiale entre les première et seconde bobines de miroir magnétique.

6. Source d'ions de la revendication 1, dans laquelle le système de confinement magnétique est configuré pour produire le champ magnétique de sorte que le champ magnétique soit symétrique en azimut autour de l'axe longitudinal dans toute la région de confinement.

7. Source d'ions de la revendication 1, dans laquelle l'excitateur de résonance cyclotronique ionique (62) est configuré pour diriger un rayonnement vers la région de confinement ayant une fréquence sensiblement accordée sur la fréquence cyclotronique ionique d'ions présentant l'état d'ionisation entraîné sélectionné dans le champ magnétique sensiblement uniforme.

8. Source d'ions de la revendication 1, dans laquelle l'excitateur de résonance cyclotronique ionique (62) est configuré pour diriger un rayonnement vers la région de confinement à une pluralité de fréquences, chaque fréquence étant sensiblement accordée sur la fréquence cyclotronique ionique, dans le champ magnétique sensiblement uniforme, d'ions présentant un état d'ionisation sélectionné respectif autre que l'état d'ionisation de sortie souhaité.

9. Source d'ions de la revendication 7, dans laquelle l'antenne d'excitateur de résonance cyclotronique ionique est choisie dans le groupe constitué par : une antenne bifilaire torsadée, une antenne filaire torsadée, une antenne bifilaire non torsadée ou une antenne filaire non torsadée.

10. Source d'ions de la revendication 1, dans laquelle :
la première bobine de miroir magnétique est configurée pour produire le premier miroir magnétique de sorte qu'une partie du champ magnétique s'étende à l'extérieur de la région de confinement ;
le dispositif d'entraînement de résonance cyclotronique électronique est accordé sur la fréquence cyclotronique électronique correspondant à la partie du champ magnétique s'étendant à l'extérieur de la région de confinement pour entraîner un mouvement cyclotronique d'électrons non confinés dans ladite partie du champ, dans laquelle lesdits électrons non confinés interagissent avec le gaz dans la chambre pour former un plasma non confiné ; et
la source d'ions comprend en outre une cible de pulvérisation (220) située dans la chambre à proximité de ladite partie du champ magnétique, dans laquelle la source d'ions est polarisée pour attirer des ions du plasma non confiné, et la source de pulvérisation est configurée pour émettre des particules neutres en réponse à des collisions avec les ions attirés afin de former au moins une partie du gaz dans la chambre.

11. Source d'ions de la revendication 10, dans laquelle la cible de pulvérisation comprend au moins l'un sélectionné dans la liste constituée par : un anneau de matériau disposé autour de l'axe longitudinal, un anneau de matériau disposé autour de l'axe longitudinal et présentant une surface cible inclinée par rapport à l'axe longitudinal, ou un matériau cible positionné autour de l'axe longitudinal et s'étendant le long de celui-ci.

12. Source d'ions de la revendication 11, comprenant en outre un extracteur configuré pour extraire de la région de confinement un faisceau d'ions He, dans laquelle le faisceau comprend des ions ⁴He⁺⁺ ou ³He⁺⁺.

13. Source d'ions de la revendication 1, dans laquelle l'aimant (42), qui comprend l'aimant multipolaire du système de confinement magnétique, est configuré pour produire un champ magnétique dirigé de manière azimutale par rapport à l'axe longitudinal dont l'amplitude diminue radialement à mesure que la proximité par rapport à l'axe augmente, sauf le long d'une ou plusieurs cuspides.

14. Source d'ions de la revendication 1, dans laquelle le dispositif d'entraînement de résonance cyclotronique électronique est configuré pour produire un champ électrique variable dans le temps ayant une fréquence qui entraîne le mouvement cyclotronique d'électrons situés dans une première région (180) du premier champ magnétique généré par la première bobine de miroir magnétique et dans une seconde région (182) du second champ magnétique, mais qui est sensiblement désaccordée par rapport à la fréquence de résonance cyclotronique électronique correspondant au champ magnétique sensiblement uniforme de la région de confinement.
